(19) **Europäisches Patentamt / European Patent Office / Office européen des brevets**

(11) **EP 4 412 086 B1**

(12) **FASCICULE DE BREVET EUROPÉEN**

(45) Date de publication et mention de la délivrance du brevet:
**25.06.2025 Bulletin 2025/26**

(51) Classification Internationale des Brevets (IPC):
**H03K 19/0175** (2006.01)    **G06N 10/00** (2022.01)

(52) Classification Coopérative des Brevets (CPC):
**H03K 19/0175; G06N 10/40**

(21) Numéro de dépôt: **24154180.4**

(22) Date de dépôt: **26.01.2024**

(54) **FOURNITURE D'UN SIGNAL NUMÉRIQUE À RAMPES**

**BEREITSTELLUNG EINES DIGITALEN RAMPENSIGNALS**

**PROVIDING A DIGITAL SIGNAL WITH RAMPS**

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité: **01.02.2023 FR 2300946**
**14.02.2023 FR 2301359**

(43) Date de publication de la demande:
**07.08.2024 Bulletin 2024/32**

(73) Titulaire: **Commissariat à l'Energie Atomique et aux Energies Alternatives**
**75015 Paris (FR)**

(72) Inventeurs:
• **TOUBEIX, Mathieu**
  **38054 Grenoble Cedex 09 (FR)**
• **GUTHMULLER, Eric**
  **38054 Grenoble Cedex 09 (FR)**
• **EVANS, Adrian**
  **38054 Grenoble Cedex 09 (FR)**

(74) Mandataire: **Cabinet Beaumont**
**4, Place Robert Schuman**
**B.P. 1529**
**38025 Grenoble Cedex 1 (FR)**

(56) Documents cités:
**US-A1- 2009 231 479**

• **MARTIJN F SNOEIJ ET AL: "Multiple-Ramp Column-Parallel ADC Architectures for CMOS Image Sensors", IEEE JOURNAL OF SOLID-STATE CIRCUITS, IEEE, USA, vol. 42, no. 12, 1 December 2007 (2007-12-01), pages 2968 - 2977, XP011197063, ISSN: 0018-9200, DOI: 10.1109/ JSSC.2007.908720**

# EP 4 412 086 B1

**Description**

La présente demande de brevet revendique la priorité des demandes de brevet français FR2301359 et FR2300946.

## Domaine technique

La présente description concerne de façon générale les circuits de fourniture de signaux numériques à rampes.

## Technique antérieure

Pour certaines applications, on souhaite obtenir un circuit électronique permettant de fournir un signal numérique correspondant à une succession de rampes.

US 2009/231479 A1 divulgue un DAC qui délivre des signaux de rampe correspondant aux pixels d'un capteur d'images. Un exemple d'application concerne la commande de cellules de stockage de bits quantiques par un signal de commande analogique obtenu par conversion numérique-analogique du signal numérique. Pour de telles applications, il peut être souhaitable de pouvoir modifier de façon simple la succession de rampes du signal numérique. Il peut en outre être souhaitable que le signal numérique soit fourni à haute fréquence, c'est-à-dire avec une précision temporelle fine.

Toutefois, il peut être souhaitable d'utiliser un circuit électronique cadencé par un signal d'horloge à une fréquence inférieure à la granularité souhaitée du signal numérique.

## Résumé de l'invention

Un mode de réalisation pallie tout ou partie des inconvénients des circuits de fourniture de signaux numériques à rampes connus.

Un mode de réalisation prévoit un circuit électronique de fourniture d'un signal numérique comprenant une succession de rampes, le circuit électronique étant cadencé par un signal d'horloge, le circuit électronique étant configuré pour fournir un nombre Nout de valeurs numériques du signal numérique à chaque cycle du signal d'horloge, Nout étant strictement supérieur à 1, le circuit électronique comprenant une première mémoire dans laquelle sont stockées, pour chaque rampe, des premières données comprenant une valeur de début de la rampe, la pente de la rampe, et une durée restante de la rampe dans le dernier cycle du signal d'horloge dans lequel s'étend la rampe, et une deuxième mémoire dans laquelle sont stockées des deuxièmes données relatives aux nombres de cycles du signal d'horloge sur lesquels s'étendent certaines des rampes, et un premier circuit configuré pour lire dans la première mémoire les premières données relatives à plusieurs rampes successives et dans la deuxième mémoire les deuxièmes données associées auxdites plusieurs rampes successives, et pour fournir lesdites valeurs numériques à partir des premières et deuxièmes données lues.

Selon un mode de réalisation, le premier circuit est configuré pour lire en parallèle dans la première mémoire les premières données relatives à Nout rampes successives, pour lire dans la deuxième mémoire les deuxièmes données associées auxdites Nout rampes successives, et pour fournir, à un cycle du signal d'horloge, Nout valeurs numériques du signal numérique faisant partie d'une à Nout rampes parmi lesdites Nout rampes

Selon un mode de réalisation, le premier circuit comprend Nout circuits d'interpolation en parallèle, chaque circuit d'interpolation étant configuré pour calculer, à un cycle du signal d'horloge, l'une des Nout valeurs numériques du signal numérique faisant partie d'une à Nout rampes parmi lesdites Nout rampes successives.

Selon un mode de réalisation, les premières données stockées dans la première mémoire comprennent, pour chaque rampe, des coefficients d'un polynôme de degré supérieur ou égal à 2, la pente de la rampe étant le coefficient de degré 1 du polynôme, le premier circuit étant configuré pour fournir lesdites valeurs numériques de rampes correspondant à des fonctions polynomiales.

Selon un mode de réalisation, Nout est une puissance de deux, en particulier 2, 4, 8, ou 16.

Selon un mode de réalisation, le premier circuit est configuré pour lire, dans la première mémoire, simultanément les premières données de Nout rampes successives.

Selon un mode de réalisation, le premier circuit est configuré pour lire, dans la deuxième mémoire, simultanément les deuxième données de Nout rampes successives.

Selon un mode de réalisation, le premier circuit comprend un premier module configuré pour fournir, à chaque cycle du signal d'horloge, des ensembles de données, chaque ensemble comprenant une valeur de début de rampe, la pente de la rampe, et un délai, le délai variant d'un ensemble à l'autre, et un deuxième module configuré, pour chaque ensemble, à fournir une valeur numérique du signal numérique égale à la somme de la valeur de début de la rampe et du produit de la pente de la rampe et du délai.

Selon un mode de réalisation, la première mémoire comprend Nout blocs mémoire en parallèle.

Selon un mode de réalisation, le circuit électronique comprend une troisième mémoire dans laquelle sont stockées, pour chaque rampe de la succession de rampes, des troisièmes données comprenant la valeur de début de la rampe, la valeur de fin de la rampe, et la durée de la rampe, le circuit électronique comprenant en outre un deuxième circuit configuré pour fournir, à partir des troisièmes données, les premières données et les deuxièmes données, et pour écrire les premières données dans la première mémoire et pour écrire les deuxièmes données dans la deuxième mémoire.

Selon un mode de réalisation, le deuxième circuit est configuré pour traiter les troisièmes données par lots de Nout rampes successives.

Selon un mode de réalisation, le deuxième circuit comprend un troisième module configuré pour déterminer, pour chaque rampe, la pente de la rampe, et un quatrième module configuré pour déterminer la durée totale écoulée depuis le début de la succession de rampes jusqu'à la fin de la rampe et le nombre de cycles du signal d'horloge contenu dans ladite durée totale.

Un mode de réalisation prévoit également un système comprenant le circuit électronique tel que défini précédemment, un convertisseur numérique-analogique configuré pour convertir le signal numérique en un signal analogique, et des cellules de stockage de bits quantiques recevant le signal analogique.

Un mode de réalisation prévoit également un procédé de fourniture d'un signal numérique comprenant une succession de rampes comprenant la fourniture, à chaque cycle d'un signal d'horloge, d'un nombre Nout de valeurs numériques du signal numérique, Nout étant strictement supérieur à 1, le procédé comprenant la fourniture d'une première mémoire dans laquelle sont stockées, pour chaque rampe, des premières données comprenant une valeur de début de la rampe, la pente de la rampe, et une durée restante de la rampe dans le dernier cycle du signal d'horloge dans lequel s'étend la rampe, la fourniture d'une deuxième mémoire dans laquelle sont stockées des deuxièmes données relatives aux nombres de cycles du signal d'horloge sur lesquels s'étendent certaines des rampes, la lecture, dans la première mémoire, des premières données relatives à plusieurs rampes successives et, dans la deuxième mémoire, des deuxièmes données associées auxdites plusieurs rampes successives, et la fourniture desdites valeurs numériques à partir des premières et deuxièmes données lues.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1 représente un système de contrôle et de mesure de bits quantiques ;

la figure 2, la figure 3, la figure 4, la figure 5, et la figure 6 représentent des exemples de formes d'onde ;

la figure 7 représente la forme d'onde de la figure 6 sur laquelle on a indiqué les paramètres de données de la forme d'onde ;

la figure 8 représente la forme d'onde de la figure 7 sur laquelle on a indiqué les paramètres de contrôle de la forme d'onde ;

la figure 9 représente, de façon schématique, un mode de réalisation d'un circuit électronique configuré pour exécuter une forme d'onde ;

la figure 10 représente un mode de réalisation plus détaillé du circuit électronique de la figure 9 ;

la figure 11 illustre un mode de réalisation d'un automate fini du circuit électronique de la figure 10 ;

la figure 12 représente un mode de réalisation d'un module de division du circuit électronique de la figure 10 ;

la figure 13 illustre un mode de réalisation d'un procédé de gestion d'une mémoire du circuit électronique de la figure 10 ;

la figure 14 représente un mode de réalisation d'un module de calcul de durée du circuit électronique de la figure 10 ;

la figure 15 illustre un mode de réalisation d'un autre automate fini du circuit électronique de la figure 10 ;

la figure 16 illustre un mode de réalisation d'un procédé de fonctionnement de l'automate fini de la figure 15 ;

la figure 17 représente un mode de réalisation d'un module d'interprétation du circuit électronique de la figure 10 ; et

la figure 18 illustre un mode de réalisation d'un procédé de gestion d'une mémoire du circuit électronique de la figure 10 ;

la figure 19 illustre un autre mode de réalisation d'un procédé de gestion d'une mémoire du circuit électronique de la figure 10 ;

la figure 20 représente, de façon schématique, un autre mode de réalisation d'un circuit électronique configuré pour exécuter une forme d'onde ;

la figure 21 représente un mode de réalisation d'un système de fourniture d'un signal numérique ; et

la figure 22, la figure 23, et la figure 24 représentent des exemples de formes d'onde obtenus par essais.

Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques. Par souci de clarté, seuls les étapes et éléments utiles à la compréhension des modes de réalisation décrits ont été représentés et sont détaillés.

Sauf précision contraire, les expressions "environ", "approximativement", et "sensiblement" signifient à 10 % près, de préférence à 5 % près.

Dans la suite de la description, on appelle rampe un signal correspondant à une fonction polynomiale partant d'une valeur de départ Start_val pour arriver à une valeur de fin End_val en une durée Duration, et on appelle forme d'onde un ensemble de rampes successives. En particulier, la rampe est appelée rampe linéaire lorsque le signal partant de la valeur de départ Start_val pour arriver à la valeur de fin End_val est linéaire, et la rampe est appelée rampe non linéaire lorsque le signal partant de la valeur de départ Start_val pour arriver à la valeur de fin End_val n'est pas linéaire.

On dit qu'un circuit électronique exécute ou joue une forme d'onde lorsqu'il fournit une succession de valeurs numériques d'un signal numérique qui, après une conversion numérique-analogique, conduit à un signal analogique dont la représentation graphique correspond à la forme d'onde.

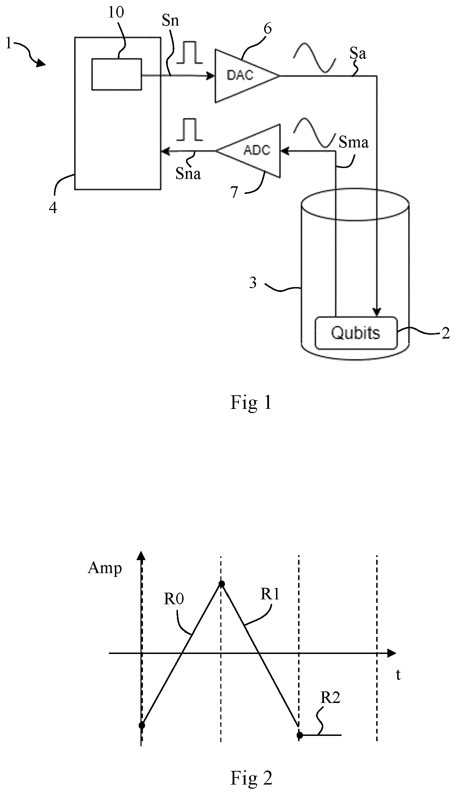

La figure 1 représente un mode de réalisation d'un système 1 comprenant :

- des cellules de stockage de bits quantiques 2 (Qubits) ;
- une enceinte froide 3 contenant les cellules de stockage de bits quantiques 2 ;
- un dispositif de traitement 4 configuré pour fournir un signal numérique Sn ;
- un convertisseur numérique-analogique 6 (DAC) qui reçoit le signal numérique Sn et fournit un signal analogique Sa d'excitation des cellules de stockage de bits quantiques 2 ; et
- un convertisseur analogique-numérique 7 (ADC) qui reçoit un signal analogique de mesure Sma issue des cellules de stockage de bits quantiques 2 et le convertit en un signal numérique de mesure Sna transmis au dispositif de traitement 4.

Le dispositif de traitement 4 comprend un circuit électronique 10 configuré pour exécuter une forme d'onde et fournir le signal numérique Sn. A titre d'exemple, le circuit électronique 10 correspond à un circuit logique programmable, notamment un réseau de portes programmables sur site (FPGA, sigle anglais pour Fiel-Programmable Gate Array), ou à un circuit intégré propre à une application (ASIC, sigle anglais pour Application-Specific Integrated Circuit).

Le circuit électronique 10 configuré pour exécuter une forme d'onde est cadencé par un signal d'horloge ayant une fréquence fhard et une période Thard. Selon un mode de réalisation, le circuit électronique 10 fournit, à chaque cycle d'horloge de durée Thard, appelé cycle matériel par la suite, un nombre Nout de valeurs numériques successives du signal numérique Sn correspondant à la forme d'onde. Nout est un nombre entier supérieur ou égal à 1, et est appelé facteur de sur-échantillonnage. Selon un mode de réalisation, Nout est une puissance de 2. On appelle fdac la fréquence égale au produit de la fréquence fhard et du facteur de sur-échantillonnage Nout, et on appelle Tdac la durée égale au rapport entre la période Thard et le facteur de sur-échantillonnage Nout. Dans le mode de réalisation illustré en figure 1, les valeurs numériques du signal numérique Sn correspondant à la forme d'onde sont fournies au convertisseur numérique-analogique 6 qui est cadencé par un signal d'horloge ayant la fréquence fdac et la période Tdac.

Chaque rampe de la forme d'onde est définie par sa valeur de début Start_val, sa valeur de fin End_val, et sa durée Duration qui est exprimée en nombre de périodes Tdac. L'ensemble des données Start_val, End_val, et Tdac des rampes de la forme d'onde sont appelées paramètres bruts de la forme d'onde. Chaque rampe de la forme d'onde peut s'étendre sur moins d'un cycle matériel, sur plus d'un cycle matériel, commencer dans un cycle matériel et se terminer dans un autre cycle matériel, etc. Ceci signifie notamment que, pour chaque rampe, le début de la rampe peut coïncider avec le début d'un cycle matériel ou se trouver à l'intérieur d'un cycle matériel et que la fin de la rampe peut coïncider avec la fin d'un cycle matériel ou se trouver à l'intérieur d'un cycle matériel. En outre, le cycle matériel du début de la rampe peut être le même que le cycle matériel de la fin de la rampe ou peut être différent du cycle matériel de la fin de la rampe.

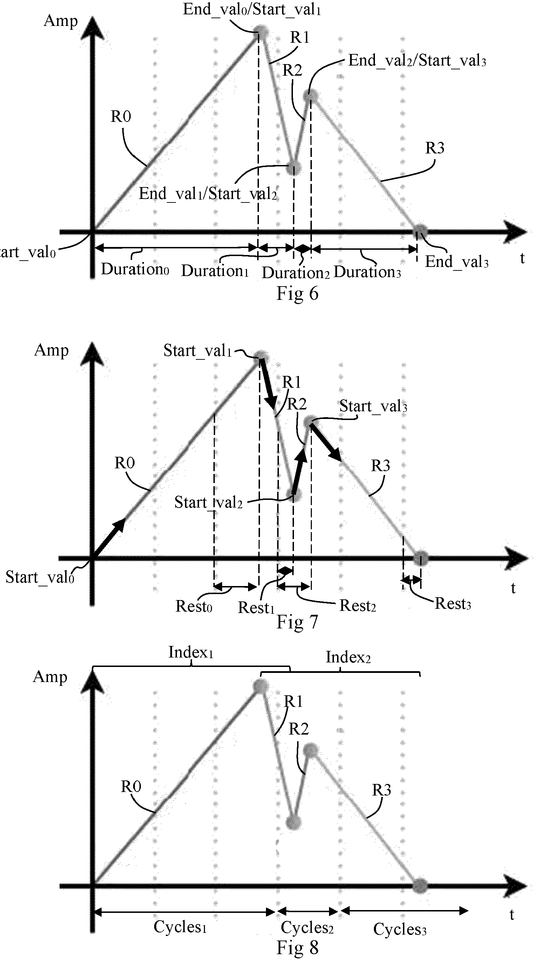

Des exemples de formes d'onde vont maintenant être décrites pour des rampes linéaires. La figure 2, la figure 3, la figure 4, la figure 5, et la figure 6 représentent des exemples de formes d'onde, par exemple des courbes d'évolution de l'amplitude Amp d'une tension en fonction du temps t. Sur la figure 2, la figure 3, la figure 4, la forme d'onde comprend trois rampes successives R0, R1, et R2, et, sur la figure 6, la forme d'onde comprend quatre rampes successives R0, R1, R2, et R3. Sur les figures 2 à 6, on a représenté en traits pointillés les cycles matériel de fonctionnement du circuit électronique 10.

Les paramètres bruts des formes d'onde représentées sur les figures 2 à 6 sont regroupés respectivement dans les tableaux Table 1 à Table 5 ci-dessous. Pour les figures 2 à 5, Nout est égal à 16. Pour la figure 6, Nout est égal à 4. Les paramètres bruts de la forme d'onde ont été ajoutés sur la figure 6.

[Table 1]

| Rampe | Paramètres bruts | | |
|---|---|---|---|
| | Start_val | End_val | Duration |
| R0 | -4500 | 4500 | 16 |
| R1 | 4500 | -4500 | 16 |
| R2 | -4600 | -4600 | 8 |

[Table 2]

| Rampe | Paramètres bruts | | |
|---|---|---|---|
| | Start_val | End_val | Duration |
| R0 | -4500 | 4500 | 1 |
| R1 | 4500 | -4500 | 1 |
| R2 | -4600 | -4600 | 24 |

[Table 3]

| Rampe | Paramètres bruts | | |
|---|---|---|---|
| | Start_val | End_val | Duration |
| R0 | -4500 | 4500 | 8 |
| R1 | 4500 | -4500 | 3 |
| R2 | -4600 | -4600 | 7 |

[Table 4]

| Rampe | Paramètres bruts | | |
|---|---|---|---|
| | Start_val | End_val | Duration |
| R0 | -4500 | 4500 | 18 |
| R1 | 4500 | -4500 | 15 |
| R2 | -4600 | -4600 | 7 |

[Table 5]

|  | Paramètres bruts | | |
| --- | --- | --- | --- |
| Rampe | Start_val | End_val | Duration |
| R0 | 0 | 4192 | 11 |
| R1 | 4192 | 1290 | 2 |
| R2 | 1290 | 2902 | 1 |
| R3 | 2902 | 0 | 7 |

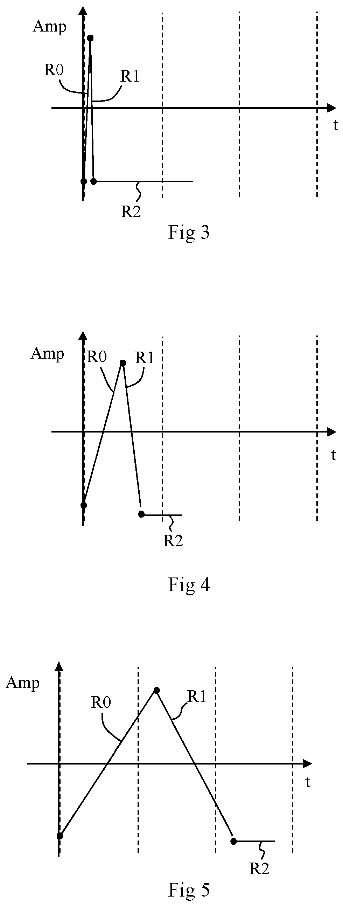

On remarque que pour les formes d'onde représentées sur les figures 3, 4, 5, et 6, certaines rampes ne commencent pas et/ou ne finissent pas à la fin d'un cycle matériel. De ce fait, un circuit électronique cadencé par un signal d'horloge à la fréquence fhard et mettant seulement en oeuvre un algorithme d'interpolation ne peut pas exécuter ces formes d'onde.

Selon un mode de réalisation, il est déterminé deux ensembles de données à partir des paramètres bruts de la forme d'onde, le premier ensemble de données est appelé paramètres de données de la forme d'onde et le deuxième ensemble de données est appelé paramètres de contrôle de la forme d'onde.

Les paramètres de données de la forme d'onde comprennent, pour chaque rampe de la forme d'onde, la valeur de début Start_val de la rampe, la pente de la rampe, appelée "Coeff", et le nombre de périodes Tdac, appelé Rest, dans le dernier cycle matériel sur lequel s'étend la rampe depuis le début de ce dernier cycle matériel. Les paramètres de données de la forme d'onde représentée en figure 6 sont regroupés dans le tableau Table 6 ci-après.

[Table 6]

|  | Paramètres de données | | |
| --- | --- | --- | --- |
| Rampe | Start_val | Coeff | Rest |
| R0 | 0 | 381,09 | 3 |
| R1 | 4192 | -1451 | 1 |
| R2 | 1290 | 1612 | 2 |
| R3 | 2902 | -414.57 | 1 |

La figure 7 représente la forme d'onde de la figure 6 sur laquelle on a indiqué les paramètres de données de la forme d'onde.

Les paramètres de contrôle de la forme d'onde permettent de rassembler les rampes dans des groupes de rampes successives. Lorsqu'une rampe se termine au milieu d'un cycle matériel, il faut pouvoir compléter le cycle matériel en cours avec un certain nombre de rampes. Ces rampes représentent un groupe. Ce groupe va être joué un certain nombre de cycles matériel, ce qui correspond à un paramètre de contrôle Cycles. Lorsqu'il se termine, le système doit obtenir l'information d'où est le début du prochain groupe de rampe à jouer via le paramètre de contrôle Index. Les paramètres de contrôle de la forme d'onde représentée en figure 6 sont regroupés dans le tableau Table 7 ci-après.

[Table 7]

| Paramètres de contrôle | |
| --- | --- |
| Cycles | Index |
| 2 | 1 |
| 0 | 2 |
| 1 | - |

La figure 8 représente la forme d'onde de la figure 6 sur laquelle on a illustré les paramètres de contrôle de la forme d'onde.

Un mode de réalisation d'un circuit électronique configuré pour exécuter une forme d'onde à partir des paramètres bruts de la forme d'onde va maintenant être décrit dans le cas d'une forme d'onde comprenant des rampes linéaires.

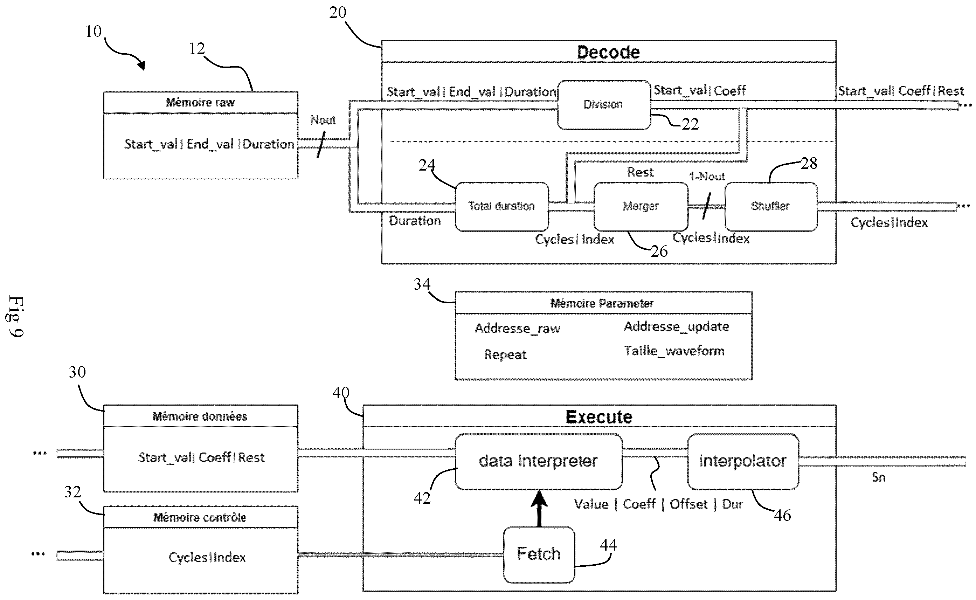

La figure 9 représente, de façon schématique, un mode de réalisation du circuit électronique 10 configuré pour exécuter une forme d'onde à partir des paramètres bruts de la forme d'onde.

Le circuit électronique 10 comprend :

- une mémoire 12 (Mémoire raw) dans laquelle sont stockés les paramètres bruts de la forme d'onde Start_val, End_val, Duration ;
- un circuit de décodage 20 (Decode) configuré pour fournir les paramètres de données Start_val, Coeff, Rest et les paramètres de contrôle Cycles, Index de la forme d'onde à partir des paramètres bruts de la forme d'onde stockés dans la mémoire 12 ;
- une mémoire 30 (Mémoire données), également appelée mémoire de données 30, dans laquelle sont stockés les paramètres de données Start_val, Coeff, Rest de la forme d'onde fournis par le circuit de décodage 20 ;
- une mémoire 32 (Mémoire contrôle), également appelée mémoire de contrôle 32, dans laquelle sont stockés les paramètres de contrôle Cycles, Index de la forme d'onde fournis par le circuit de décodage 20 ; et
- un circuit d'exécution 40 (Execute) configuré pour déterminer les valeurs numériques successives du signal numérique Sn correspondant à la forme d'onde à partir des paramètres de données Start_val, Coeff, Rest stockés dans la mémoire de données 30 et des paramètres de contrôle Cycles, Index stockés dans la mémoire de contrôle 32.

Selon un mode de réalisation, le circuit électronique 10 comprend en outre une mémoire 34 (Mémoire Parameter) dans laquelle sont stockés, pour chaque forme d'onde, des paramètres de configuration de la forme d'onde Repeat, Taille_waveform et les adresses de début de lecture Address_raw dans la mémoire 12 et les adresses de début de lecture Addresse_update dans les mémoires 30 et 32.

Le circuit de décodage 20 comprend :

- un module de division 22 (Division) configuré pour recevoir les paramètres brus Start_val, End_val, Duration stockés dans la mémoire 12 et fournir les paramètres de données Start_val, et Coeff ;
- un module de calcul de durée 24 (Total duration) configuré pour recevoir les paramètres bruts Duration stockés dans la mémoire 12, déterminer la durée totale de chaque rampe de la forme d'onde et fournir le paramètre de données Rest et les paramètres de contrôle Cycles, Index ;
- un module de fusion 26 (Merger) configuré pour recevoir les paramètres de contrôle Cycles, Index déterminés par le module de calcul de durée 24, et fournir les paramètres de contrôle Cycles, Index modifiés ; et
- un module de réorganisation 28 (Shuffler) configuré pour recevoir les paramètres de contrôle Cycles, Index déterminés par module de fusion 26 et fournir les paramètres de contrôle Cycles, Index modifiés.

Le circuit d'exécution 40 comprend :

- un module d'interprétation 42 (data interpreter) recevant les paramètres de données Start_val, Coeff, et Rest de la forme d'onde à exécuter stockés dans la mémoire de données 30, et fournissant des données Value, Coeff, Offset, et Dur ;
- un module de recherche 44 (Fetch) recevant les paramètres de contrôle Cycles et Index stockés dans la mémoire de contrôle 32 et commandant le fonctionnement du module d'interprétation 42 ; et
- un module d'interpolation 46 (interpolator) configuré pour recevoir les données Value, Coeff, Offset, et Dur fournies par le module d'interprétation 42 et fournir les valeurs numériques du signal numérique Sn correspondant à la forme d'onde.

Un mode de réalisation d'un procédé de fourniture des paramètres de données Start_val, Coeff, et Rest et des paramètres de contrôle Cycles et Index d'une forme d'onde par le circuit de décodage 20 à partir des paramètres bruts Start_val, End_val, Duration de la forme d'onde va maintenant être décrit. Selon un mode de réalisation, le circuit de décodage 20 traite les paramètres bruts stockés dans la mémoire 12 par lots et lit simultanément les paramètres bruts relatifs à Nout rampes successives de la forme d'onde.

Pour chaque rampe des Nout rampes successives de la forme d'onde, le module de division 22 détermine le paramètre de données Coeff de la rampe en déterminant la différence entre la valeur de fin End_val et la valeur de début Start_val de la rampe et en divisant cette différence par la durée Duration de la rampe. Les paramètres de données Coeff des Nout rampes successives de la forme d'onde sont ainsi obtenus.

Pour chaque rampe des Nout rampes successives de la forme d'onde, le module de calcul de durée 24 détermine la donnée Total et le paramètre de données Rest. La donnée Total est égale au nombre de cycles matériel entièrement écoulés depuis le début de la première rampe du lot de Nout rampes jusqu'à la fin de la rampe considérée. Le paramètre de données Rest est égal à 0 dans le cas où la rampe considérée s'achève en même temps qu'un cycle matériel et est égal au nombre de périodes Tdac dans le dernier cycle matériel sur lequel s'étend la rampe considérée depuis le début de ce dernier cycle dans le cas où la rampe considérée ne s'achève pas en même temps qu'un cycle matériel. Dans le cas de la forme d'onde représentée sur la figure 6, le module de calcul de durée 24 fournit les données regroupées dans le tableau Table 8 ci-dessous :

[Table 8]

|  | Module de calcul de durée | |
| --- | --- | --- |
| Rampe | Total | Rest |
| R0 | 2 | 3 |
| R1 | 3 | 1 |
| R2 | 3 | 2 |
| R3 | 5 | 1 |

Selon un mode de réalisation, la détermination des paramètres de contrôle Cycles et Index des Nout rampes successives de la forme d'onde est réalisée par le module de fusion 26 selon un procédé comprenant cinq étapes.

Selon un mode de réalisation, pour chaque rampe du lot de Nout rampes successives de la forme d'onde en cours de traitement, la première étape consiste à calculer le cycle matériel de sortie de la rampe, c'est-à-dire le dernier cycle matériel où elle est jouée et en déduire le nombre de cycles à jouer depuis la dernière rampe. Cela correspond au quotient de la durée totale Total avec le sur-échantillonnage Nout moins le cycle de sortie de la précédente rampe. Il y a deux exceptions à prendre en compte, cela vient du fait qu'une rampe alignée avec la fin d'un cycle matériel à son dernier cycle joué qui empiète sur le suivant. Lorsque la rampe finit alignée avec la fin d'un cycle matériel (c'est-à-dire lorsque le paramètre de données Rest est égal à 0) et que la dernière rampe ne l'était pas, il faut retirer un cycle matériel à jouer. Lorsque la précédente rampe a fini alignée avec un cycle matériel mais que celle-ci ne l'est pas, elle doit être jouée un cycle de plus.

Selon un mode de réalisation, à la première étape, pour chaque rampe des Nout rampes successives de la forme d'onde, le module de fusion 26 détermine donc le paramètre de contrôle Cycles de la rampe de la façon suivante :

- dans le cas où le paramètre de données Rest de la rampe est égal à 0 et le paramètre de données Rest de la rampe précédente est différent de 0, le paramètre de contrôle Cycles de la rampe est égal à la différence entre la donnée Total de la rampe et la donnée Total de la rampe précédente, le tout diminué de 1 ;
- dans le cas où le paramètre de données Rest de la rampe est différent de 0 et le paramètre de données Rest de la rampe précédente est égal à 0, le paramètre de contrôle Cycles de la rampe est égal à la différence entre la donnée Total de la rampe et la donnée Total de la rampe précédente, le tout augmenté de 1 ; et
- dans le cas où le paramètre de données Rest de la rampe est égal à zéro et le paramètre de données Rest de la rampe précédente est égal à 0 ou dans le cas où le paramètre de données Rest de la rampe est différent de zéro et le paramètre de données Rest de la rampe précédente est différent de 0, le paramètre de contrôle Cycles de la rampe est égal à la différence entre la donnée Total de rampe et la donnée Total de la rampe précédente.

Lors du traitement d'un lot de Nout rampes, le module de fusion 26 conserve en mémoire le paramètre de données Rest de la dernière rampe du lot précédent de façon à pouvoir déterminer le paramètre de contrôle Cycles de la première rampe du nouveau lot traité. La première rampe de la forme d'onde est traitée comme les autres, seulement, lors du traitement de la première rampe, on considère qu'il y a une rampe "précédente" fictive dont le paramètre de données Rest est égal à 0.

Dans le cas de la forme d'onde représentée sur la figure **6,** le module de fusion 26 fournit, à la première étape, les données regroupées dans le tableau Table 9 ci-dessous :

[Table 9]

|  | Fusion - Etape 1 |
| --- | --- |
| Rampes | Cycles |
| R0 | 3 |
| R1 | 1 |
| R2 | 0 |
| R3 | 2 |

A une deuxième étape, le module de fusion 26 détermine une donnée Block pour chaque rampe du lot de Nout rampes. Pour chaque rampe, dans le cas où le paramètre de contrôle Cycles de la rampe est égal à 0 et que le paramètre de données Rest de la rampe précédente est différent de 0, la donnée Block de la rampe est égale à 0, sinon la donnée Block est égale à 1. Pour le traitement de la première rampe de la forme d'onde, on considère qu'il y a une rampe "précédente" fictive dont le paramètre de données Rest est égal à 0 et le paramètre de contrôle Cycles est égal à 0. La deuxième étape consiste donc à indiquer les débuts de groupes de rampes. Si le paramètre de contrôle Cycles de la rampe est égal à 0, la rampe n'est pas le début d'un groupe de rampes, sinon elle l'est. Il y a une exception : si la rampe précédente finit alignée avec la fin d'un cycle matériel, la rampe suivante est nécessairement dans un nouveau groupe de rampes même si la donnée Cycle de la rampe est égal à 0. Dans le cas de la forme d'onde représentée sur la figure 6, le module de fusion 26 détermine à la deuxième étape les données regroupées dans le tableau Table 10 ci-dessous :

[Table 10]

| Rampes | Fusion - Etape 2 | |
| --- | --- | --- |
| | Cycles | Block |
| R0 | 3 | 1 |
| R1 | 1 | 1 |
| R2 | 0 | 0 |
| R3 | 2 | 1 |

A une troisième étape, le module de fusion 26 détermine, pour chaque rampe du lot de Nout rampes, une donnée Blocksum qui est égale à la somme des données Block de toutes les rampes du lot de Nout rampes depuis le début du lot incluant la rampe considérée. Dans le cas de la forme d'onde représentée sur la figure 6, le module de fusion 26 détermine à la troisième étape les données regroupées dans le tableau Table 11 ci-dessous :

[Table 11]

| Rampes | Fusion - Etape 3 | | |
| --- | --- | --- | --- |
| | Cycles | Block | Blocksum |
| R0 | 3 | 1 | 1 |
| R1 | 1 | 1 | 2 |
| R2 | 0 | 0 | 2 |
| R3 | 2 | 1 | 3 |

A une quatrième étape, le module de fusion 26 détermine des valeurs du paramètre de contrôle Index. Dans ce but, on associe un indice à chaque rampe des Nout rampes traitées par le module de fusion 26, la première rampe des Nout rampes ayant l'indice 0 et la dernière rampe des Nout rampes ayant l'indice Nout-1. On regarde chaque valeur possible de la donnée Blocksum. La donnée Blocksum peut varier entre 1 et Nout. Dans le cas où la donnée Blocksum d'aucune rampe du lot de Nout rampes n'a la valeur considérée, rien n'est fait. Dans le cas où la donnée Blocksum d'une seule rampe du lot de Nout rampes a la valeur de donnée Blocksum considérée, le paramètre de contrôle Index, à l'indice égal à la valeur de donnée Blocksum considérée diminuée d'une unité, est égal à l'indice de la rampe considérée. Dans le cas où la donnée Blocksum d'au moins deux rampes a la valeur de donnée Blocksum considérée, le paramètre de contrôle Index, à l'indice égal à la valeur de donnée Blocksum considérée diminuée d'une unité, est égal à l'indice le plus faible de ces rampes. La quatrième étape vise donc à déterminer la taille des groupes de rampes et leur position dans l'ensemble de Nout rampes traitées par le module de fusion 26. Dans le cas de la forme d'onde représentée sur la figure 6, le module de fusion 26 détermine à la quatrième étape les données regroupées dans le tableau Table 12 ci-dessous. Dans cet exemple, Nout étant égal à 4, les valeurs possibles de la donnée Blocksum varie entre 1 et 4. On cherche la valeur 4 dans la colonne Blocksum : elle ne s'y trouve pas. On cherche ensuite la valeur 3 dans la colonne Blocksum, on la trouve pour la rampe R3. Le paramètre de contrôle Index à la position 2 est donc égal à 3. On cherche ensuite la valeur 2 dans la colonne Blocksum que l'on trouve pour les rampes R1 et R2, on retient donc la rampe R1. Le paramètre de contrôle Index à la position 1 est donc égal à 1. On cherche ensuite la valeur 1 dans la colonne Blocksum que l'on trouve pour la rampe R0. Le paramètre de contrôle Index à la position 1 est donc égal à 0.

[Table 12]

| Rampes | Fusion - Etape 4 | | | |
|--------|--------|------|----------|-------|
|        | Cycles | bloc | Blocksum | Index |
| R0 | 3 | 1 | 1 | 0 |
| R1 | 1 | 1 | 2 | 1 |
| R2 | 0 | 0 | 2 | 3 |
| R3 | 2 | 1 | 3 | 0 |

Le module de fusion 26 détermine, à une cinquième étape, la version finale des paramètres de contrôle Cycles et Index du lot de Nout rampes de la forme d'onde pour un stockage dans la mémoire de contrôle 32. Pour chaque indice du paramètre de contrôle Index obtenu à la quatrième étape, le paramètre de contrôle Cycles à l'indice considéré est égal au paramètre de contrôle Cycles obtenu à la quatrième étape, diminué d'une unité, à l'indice égal au paramètre de contrôle Index obtenu à la quatrième étape à l'indice considéré. En outre, le paramètre de contrôle Index à l'indice considéré est égal à la différence entre le paramètre de contrôle Index obtenu à la quatrième étape, à l'indice considéré augmenté d'une unité, et le paramètre de contrôle Index obtenu à la quatrième étape à l'indice considéré. La version finale des paramètres de contrôle Cycles et Index de la forme d'onde représentée en figure 6 sont regroupés dans le tableau Table 7 ci-avant.

L'exécution de la forme d'onde est réalisée par le circuit d'exécution 40. Plus précisément, le module d'interprétation 42 lit les paramètres de données de la forme d'onde dans la mémoire de données 30 et le module de recherche 44 lit les paramètres de contrôle les paramètres de données de la forme d'onde dans la mémoire de contrôle 32. A chaque cycle matériel, le module d'interprétation 42 transmet au module d'interpolation 46 Nout ensembles de valeurs, chaque ensemble comprenant une donnée Value, une donnée Dur, une donnée Offset, et une donnée Coeff.

A chaque cycle matériel, le module d'interpolation 46 détermine Nout valeurs numériques Point du signal numérique Sn à partir des Nout ensembles de données reçus. Chaque valeur numérique Point est obtenue selon la relation suivante :

[Math 1]

$$Point = Value + (Dur + Offset) * Coeff$$

Le module d'interpolation 46 comprend Nout sous-modules d'interpolation en parallèle, chaque sous-module d'interpolation étant configuré pour calculer l'une des Nout valeurs numériques Point du signal numérique Sn à partir de l'un des ensembles de valeurs comprenant une donnée Value, une donnée Dur, une donnée Offset, et une donnée Coeff.

L'exécution de la forme d'onde représentée sur la figure 6 va maintenant être décrite. lors de l'exécution de cette forme d'onde par le circuit d'exécution 40, le module d'interprétation 42 lit dans la mémoire de données 30 en permanence les paramètres de données de Nout rampes successives de la forme d'onde. Dans le cas de la forme d'onde représenté sur la figure 6, le circuit d'exécution 40 lit donc les paramètres de données du tableau Table 6. Au premier cycle matériel, le circuit d'exécution 40 traite les paramètres de données de la première rampe qui sont stockés dans un registre de données indiqué dans le tableau Table 13 ci-dessous.

[Table 13]

| Registre de données - Cycle 1 | | | |
|-------|-------|--------|------|
| Value | Coeff | Offset | Rest |
| 0 | 381,09 | 0 | 3 |

Les paramètres de données des Nout rampes suivantes sont lus dans une fenêtre de lecture indiquée dans le tableau Table 14 ci-dessous.

[Table 14]

| Fenêtre de lecture - Cycle 1 | | |
|-----------|-------|------|
| Start_val | Coeff | Rest |
| 4192 | -1451 | 1 |

(suite)

| Fenêtre de lecture - Cycle 1 | | |
|---|---|---|
| Start_val | Coeff | Rest |
| 1290 | 1612 | 2 |
| 2902 | -414,57 | 1 |
| x | x | x |

Les paramètres de contrôle de la forme d'onde de la figure 6 lus par le module de recherche 44 sont indiqués dans le tableau Table 15 ci-dessous. Au premier cycle matériel, le module de recherche 44 stocke en mémoire une donnée Current_cycle égale à la valeur du paramètre de contrôle Cycles de la première ligne du tableau Table 7 et une donnée Current_Index égale à la valeur du paramètre de contrôle Index de la première ligne du tableau Table 7.

[Table 15]

| Module de recherche - Cycle 1 | |
|---|---|
| Current_cycle | Current_Index |
| 2 | 1 |

Comme Nout est égal 4, le module d'interprétation 42 fournit au module d'interpolation 46 quatre ensembles de valeurs, chacun comprenant la donnée Value égale à 0, la donnée Coeff égale à 381,09, la donnée Offset égale à 0, et la donnée Dur respectivement égale à 0, Tdac, 2*Tdac, et 3*Tdac.

Au deuxième cycle matériel, le module d'interprétation 42 ajoute la valeur Nout*Coeff à la donnée Value utilisée au premier cycle matériel. Ceci ne nécessite pas la réalisation d'une multiplication car Nout est une puissance de deux. Le module d'interprétation 42 met donc à jour la donnée Value comme cela est indiqué dans le tableau Table 16 ci-dessous. La fenêtre de lecture de Nout rampes successives par le module d'interprétation 42 ne bouge pas et est représentée dans le tableau Table 17 ci-dessous. De plus, le module de recherche 44 met à jour le paramètre de contrôle Current_cycle comme cela est indiqué dans le tableau Table 18 ci-dessous.

[Table 16]

| Registre de données - Cycle 2 | | | |
|---|---|---|---|
| Value | Coeff | Offset | Rest |
| 1524,36 | 381,09 | 0 | 3 |

[Table 17]

| Fenêtre de lecture - Cycle 2 | | |
|---|---|---|
| Start_val | Coeff | Rest |
| 4192 | -1451 | 1 |
| 1290 | 1612 | 2 |
| 2902 | -414,57 | 1 |
| x | x | x |

[Table 18]

| Module de recherche - Cycle 2 | |
|---|---|
| Current_cycle | Current _Index |
| 1 | 1 |

Le module d'interprétation 42 fournit au module d'interpolation 46 quatre ensembles de valeurs, chacun comprenant la donnée Value égale à 1524,36, la donnée Coeff égale à 381,09, la donnée Offset égale à 0, et la donnée Dur respectivement égale à 0, Tdac, 2*Tadc, et 3*Tdac.

Au troisième cycle matériel, le module d'interprétation 42 ajoute la valeur Nout*Coeff à la donnée Value utilisée au deuxième cycle matériel. Le module d'interprétation 42 met donc à jour la donnée Value comme cela est indiqué dans le tableau Table 19 ci-dessous. La fenêtre de lecture de Nout rampes successives par le module d'interprétation 42 ne bouge pas et est représentée dans le tableau Table 20 ci-dessous. De plus, le module de recherche 44 met à jour la donnée Current_cycle comme cela est indiqué dans le tableau Table 21 ci-dessous.

[Table 19]

| Registre de données - Cycle 3 | | | |
|---|---|---|---|
| Value | Coeff | Offset | Rest |
| 3048, 72 | 381,09 | 0 | 3 |

[Table 20]

| Fenêtre de lecture - Cycle 3 | | |
|---|---|---|
| Start_val | Coeff | Rest |
| 4192 | -1451 | 1 |
| 1290 | 1612 | 2 |
| 2902 | -414,57 | 1 |
| x | x | x |

[Table 21]

| Module de recherche - Cycle 3 | |
|---|---|
| Current_cycle | Current _Index |
| 0 | 1 |

Comme la donnée Cycles en cours est égale à 0 et la donnée Rest est égale à 3, le module d'interprétation 42 fournit au module d'interpolation 46 quatre ensembles de valeurs, dont trois ensembles de valeurs comprenant chacun la donnée Value égale à 3048, 72, la donnée Coeff égale à 381,09, la donnée Offset égale à 0, et la donnée Dur respectivement égale à 0, Tdac, et 2*Tadc, et un quatrième ensemble de valeur comprenant la donnée Value égale à 4192, la donnée Coeff égale à -1451, la donnée Offset égale à 0, et la donnée Dur égale à 0. Le quatrième ensemble de valeur est déterminé avec les données présentes à la première ligne du tableau Table 20 désignée par la valeur de l'index Index en cours du tableau Table 21.

Au quatrième cycle matériel, le module d'interprétation 42 met à jour la donnée Value, la donnée Coeff, la donnée Offset, et la donnée Rest comme cela est indiqué dans le tableau Table 22 ci-dessous. La fenêtre de lecture de Nout rampes successives par le module d'interprétation 42 est décalée, comme cela est représentée dans le tableau Table 23 ci-dessous. De plus, le module de recherche 44 met à jour les données Current_cycle et Current _Index comme cela est indiqué dans le tableau Table 24 ci-dessous, la donnée Current_cycle étant égale à la valeur du paramètre de contrôle Cycles de la deuxième ligne du tableau Table 7 et la donnée Current_Index étant égale à la valeur du paramètre de contrôle Index de la deuxième ligne du tableau Table 7.

[Table 22]

| Registre de données - Cycle 4 | | | |
|---|---|---|---|
| Value | Coeff | Offset | Rest |
| 4192 | 381, 09 | 1 | 1 |

EP 4 412 086 B1

[Table 23]

| Fenêtre de lecture - Cycle 4 | | |
|---|---|---|
| Start_val | Coeff | Rest |
| 1290 | 1612 | 2 |
| 2902 | -414,57 | 1 |
| x | x | x |
| x | x | x |

[Table 24]

| Module de recherche - Cycle 4 | |
|---|---|
| Current_cycle | Current_index |
| 0 | 2 |

Comme la donnée Cycles en cours est égale à 0, la donnée Offset est égale à 1 et la donnée Rest est égale à 1, le module d'interprétation 42 fournit au module d'interpolation 46 un ensemble de valeurs comprenant la donnée Value égale à 4192, la donnée Coeff égale à -1451, la donnée Offset égale à 1, et la donnée Dur égale à 0, puis le module d'interprétation 42 fournit au module d'interpolation 46 un ensemble de valeurs comprenant la donnée Value égale à 1290, la donnée Coeff égale à 1612, la donnée Offset égale à 0, et la donnée Dur égale à 0, et enfin deux ensembles de valeurs, chacun comprenant la donnée Value égale 2902, la donnée Coeff égale à -414,57, la donnée Offset égale à 0, et la donnée Dur respectivement égale à 0 et à Tdac.

Au cinquième cycle matériel, le module d'interprétation 42 met à jour la donnée Value, la donnée Coeff, la donnée Offset, et la donnée Rest comme cela est indiqué dans le tableau Table 25 ci-dessous. La fenêtre de lecture de Nout rampes successives par le module d'interprétation 42 est décalée, comme cela est représentée dans le tableau Table 26 ci-dessous. De plus, le module de recherche 44 met à jour les données Current_cycle et Current _index comme cela est indiqué dans le tableau Table 27 ci-dessous, la donnée Current_cycle étant égale à la valeur du paramètre de contrôle Cycles de la troisième ligne du tableau Table 7 et la donnée Current_Index étant égale à la valeur du paramètre de contrôle Index de la troisième ligne du tableau Table 7.

[Table 25]

| Registre de données - Cycle 5 | | | |
|---|---|---|---|
| Value | Coeff | Offset | Rest |
| 2902 | -414,57 | 2 | 1 |

[Table 26]

| Fenêtre de lecture - Cycle 5 | | |
|---|---|---|
| Start_val | Coeff | Rest |
| x | x | x |
| x | x | x |
| x | x | x |
| x | x | x |

[Table 27]

| Module de recherche - Cycle 5 | |
|---|---|
| Current_cycle | Current _index |
| 1 | x |

Comme la donnée Cycles en cours est égale à 1, la donnée Offset est égale à 2 et la donnée Rest est égale à 1, le

13

module d'interprétation 42 fournit au module d'interpolation 46 quatre ensembles de valeurs, chacun comprenant la donnée Value égale à 2902, la donnée Coeff égale à -414,57, la donnée Offset égale à 2, et la donnée Dur respectivement égale à 0, Tdac, 2*Tdac, et 3*Tdac.

Au sixième cycle matériel, le module d'interprétation 42 ajoute la valeur Nout*Coeff à la donnée Value utilisée au cinquième cycle matériel. Le module d'interprétation 42 met donc à jour la donnée Value comme cela est indiqué dans le tableau Table 28 ci-dessous. La fenêtre de lecture de Nout rampes successives par le module d'interprétation 42 ne bouge pas et est représentée dans le tableau Table 29 ci-dessous. De plus, le module de recherche 44 met à jour la donnée Current_cycle comme cela est indiqué dans le tableau Table 29 ci-dessous.

[Table 28]

| Registre de données - Cycle 6 | | | |
|---|---|---|---|
| Value | Coeff | Offset | Rest |
| 1243,72 | -414,57 | 2 | 1 |

[Table 29]

| Fenêtre de lecture - Cycle 6 | | |
|---|---|---|
| Start_val | Coeff | Rest |
| x | x | x |
| x | x | x |
| x | x | x |
| x | x | x |

[Table 30]

| Module de recherche - Cycle 6 | |
|---|---|
| Current_cycle | Current_index |
| 0 | x |

Comme la donnée Cycles en cours est égale à 0, la donnée Offset est égale à 2 et la donnée Rest est égale à 1, le module d'interprétation 42 fournit au module d'interpolation 46 deux ensembles de valeurs, chacun comprenant la donnée Value égale à 1243,72, la donnée Coeff égale à -414,57, la donnée Offset égale à 2, et la donnée Dur respectivement égale à 0 et Tdac. Pour compléter le cycle matériel final, le module d'interprétation 42 peut fournir au module d'interpolation 46 deux ensembles de valeurs, chacun comprenant la donnée Value égale à 1243,72, la donnée Coeff égale à 0, la donnée Offset égale à 0, et la donnée Dur respectivement égale à 2*Tdac et 3*Tdac. A titre de variante, pour compléter le cycle matériel final, le module d'interprétation 42 peut fournir au module d'interpolation 46 deux ensembles de valeurs correspondant à des points déterminés.

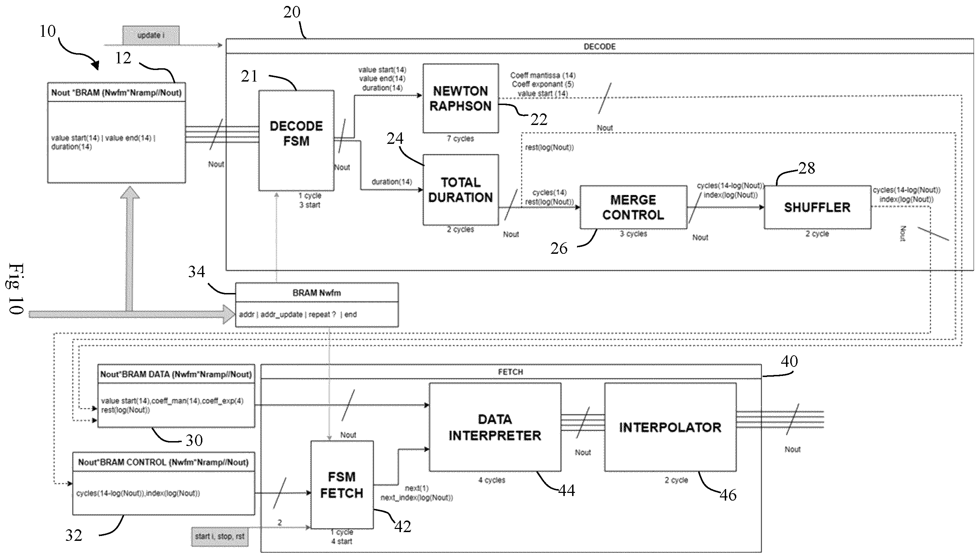

La figure 10 représente un mode de réalisation plus détaillé du circuit électronique 10 de la figure **9.**

Le circuit de décodage 20 configuré pour fournir les paramètres de données et les paramètres de contrôle de la forme d'onde à partir des paramètres bruts comprend un automate fini 21 configuré pour lire, à chaque cycle matériel, Nout ensemble de données de la mémoire 12 dans laquelle sont stockées les paramètres bruts de la forme d'onde. L'automate fini 21 est configuré pour distribuer les Nout ensemble de données au module de division 22 et au module de calcul de durée 24.

Le module de division 22 est adapté à mettre en oeuvre un algorithme de division du type Newton Raphson. Le module de division 22 reçoit la valeur de début Start_val, la valeur de fin End_val, et la durée Duration de chaque rampe. Le module de division 22 fournit Nout paramètres de données Start_val et out paramètres de données Coeff à chaque cycle matériel. Selon un mode de réalisation, le module de division 22 nécessite deux cycles matériel pour effectuer une division.

Le module de recherche 44 du circuit d'exécution 40 configuré pour déterminer les valeurs numériques de la forme d'onde à partir des paramètres de données et des paramètres de contrôle correspond à un automate fini 44 configuré pour lire, à chaque cycle matériel, les paramètres de données et le paramètres de contrôle de Nout rampes successives dans les mémoires 30 et 32.

Selon un mode de réalisation, les paramètres bruts de la forme d'onde, c'est-à-dire les données Start_val, End_val, et Duration pour chaque rampe sont stockées chacune sur un nombre NB de bits dans la mémoire 12. Selon un mode de réalisation, pour chaque rampe de la forme d'onde, le paramètre de données Start_val est stocké sur le nombre NB de bits dans la mémoire de données 30, le paramètre de données Coeff est stocké en flottant sur le nombre NB de bits de mantisse et 4 bits d'exposant dans la mémoire de données 30 et le paramètre de données Rest est stocké sur log(Nout) bits (en base 2) dans la mémoire de données 30. Selon un mode de réalisation, le paramètres de contrôle Cycles est stocké sur NB-log(Nout) bits dans la mémoire de contrôle 32 et le paramètre de contrôle Index est stocké sur log(Nout) bits (en base 2) dans la mémoire de contrôle 32. A titre d'exemple, le nombre NB de bits est égal à 14.

Selon un mode de réalisation, la mémoire 12 comprend Nout blocs mémoire BRAM en parallèle. Selon un mode de réalisation, la mémoire 30 comprend Nout blocs mémoire BRAM DATA en parallèle. Selon un mode de réalisation, la mémoire 32 comprend Nout blocs mémoire BRAM CONTROL en parallèle. Selon un mode de réalisation, la taille de la mémoire 30 est la même que la taille de la mémoire 32. Selon un mode de réalisation, la mémoire 34 comprend Nwfm blocs mémoire BRAM.

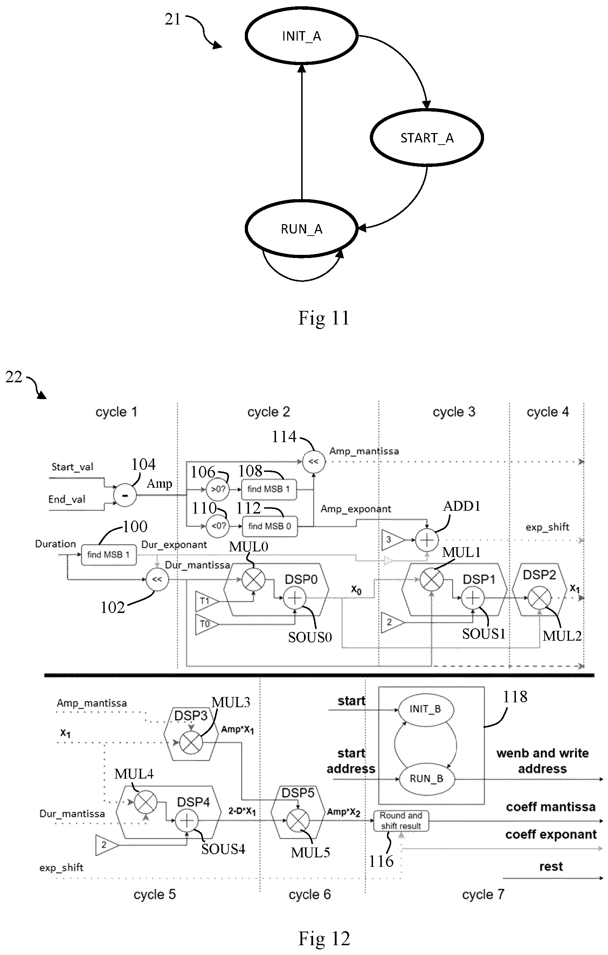

La figure 11 illustre un mode de réalisation de l'automate fini 21. Le rôle de l'automate fini est de lire les paramètres bruts, à savoir les paramètres bruts Start_val, End_val, et Duration, et de fournir, dans la mémoire 12, et de les transmettre au module de division 22 et au module de calcul de durée 24.

L'automate fini 21 comprend trois états INIT_A, START_A, et RUN_A. A l'état INIT_A, l'automate fini 21 est au repos. Le passage de l'état INI_A à l'état START_A est réalisé lorsqu'un bit update est mis à la valeur logique "1" par un système externe au circuit électronique 10. Ceci signifie que la détermination des paramètres de données et des paramètres de contrôle d'une nouvelle forme d'onde est à réaliser par le circuit de décodage 20 à partir des paramètres bruts de cette nouvelle forme d'onde qui sont stockés dans la mémoire 12. Le système externe envoie en outre au circuit électronique 10 un identifiant de la forme d'onde à exécuter. A l'état START_A, l'automate fini 21 lit, dans la mémoire 34, à partir de l'identifiant de la forme d'onde, l'adresse de lecture de la mémoire 12 à laquelle va débuter la lecture des paramètres bruts de la forme d'onde, l'adresse de la mémoire de données 30 à laquelle va débuter l'écriture des paramètres de données dans la mémoire de données 30 et l'adresse de la mémoire de contrôle 32 à laquelle va débuter l'écriture des paramètres de contrôle dans la mémoire de contrôle 32. De façon avantageuse, l'adresse de la mémoire de données 30 à laquelle va débuter l'écriture des paramètres de données est la même que l'adresse de la mémoire de contrôle 32 à laquelle va débuter l'écriture des paramètres de contrôle. L'automate fini 21 met alors un bit end_param à la valeur logique "1" ce qui entraîne le passage de l'état START_A à l'état RUN_A. A l'état RUN_A, l'automate fini 21 va lire, dans la mémoire 12, les paramètres bruts, à savoir les paramètres bruts Start_val, End_val, et Duration, de Nout rampes successives de la forme d'onde et fournit, à chaque cycle matériel, les paramètres bruts Start_val, End_val, et Duration de Nout rampes successives au module de division 22 et les paramètres bruts Duration de ces Nout rampes successives au module de calcul de durée 24. Lorsque l'automate fini 21 a transmis les paramètres bruts des dernières Nout rampes successives de la forme d'onde au module de division 22 et au module de calcul de durée 24, il met un bit end_update à la valeur logique "1" ce qui entraîne le passage de l'état RUN_A à l'état INIT_A.

La figure 12 représente un mode de réalisation du module de division 22.

Le module de division 22 reçoit les paramètres bruts Start_val, End_val, et Duration fournis par l'automate fini 21. Pour chaque rampe, la détermination du paramètre de données Coeff nécessite la détermination de l'inverse de la durée Duration de la rampe. Dans ce but, le module de division 22 met en oeuvre un algorithme itératif selon la relation suivante :

$$[\text{Math 2}]$$

$$X_{i+1} = X_i(2 - \text{Duration} * X_i)$$

où $X_i$ est une estimation de 1/Duration

L'erreur $\varepsilon_i$ entre l'estimation et 1/Duration est donnée par la relation suivante :

$$[\text{Math 3}]$$

$$\varepsilon_{i+1} = 1 - \text{Duration} * X_{i+1} = \varepsilon_i^2$$

Pour initialiser l'algorithme, $X_0$ est donné par la relation suivante :

$$[\text{Math 4}]$$

$$X_0 = T0 - T1 * \text{Duration}$$

où T0 est égal à 42/17 et T1 est égal à 32/17.

Selon un mode de réalisation, le module de division 22 réalise deux itérations de cet algorithme à une précision de 15 bits. Seules deux boucles sont suffisantes avec un arrondi sur 14 bits pour assurer une précision au bit près et donc une accumulation d'erreur sur la durée maximale de moins de 2 bits.

Le module de division 22 comprend un module 100 qui reçoit le paramètre brut Duration et qui fournit le bit Dur_exponant de poids le plus significatif du paramètre brut Duration. Le module de division 22 comprend un module 102 qui reçoit le paramètre brut Duration et qui fournit un signal Dur_mantissa égal au paramètre brut Duration dont les bits ont été décalés d'une position vers le bit de poids le plus significatif et qui correspond donc à la mantisse du paramètre brut Duration. Le signal Dur_mantissa est ainsi normalisé entre 0,5 et 1.

Le module de division 22 comprend un bloc DSP0 réalisant l'initialisation de l'algorithme en mettant en oeuvre la relation Math 4 et comprenant un multiplicateur MUL0 recevant le signal Dur_mantissa et le signal T1 et fournissant le produit du signal Dur_mantissa et du signal T1 et comprenant un soustracteur SOUS0 recevant le signal fourni par le multiplicateur MUL0 et le signal T1 et fournissant le signal $X_0$.

Le module de division 22 comprend des blocs DSP1 et DSP2 mettant en oeuvre une première itération selon la relation Math 2. Le bloc DSP1 comprend un multiplicateur MUL1 recevant le signal $X_0$ et le signal Dur_mantissa et fournissant le produit du signal $X_0$ et du signal Dur_mantissa et comprenant un soustracteur SOUS1 recevant le signal fourni par le multiplicateur MUL1 et le chiffre 2 et fournissant la différence entre le chiffre 2 et le signal fourni par le multiplicateur MUL1. Le bloc DSP2 comprend un multiplicateur MUL2 recevant le signal fourni par le soustracteur SOUS1 et le signal $X_0$ et fournissant le signal $X_1$.

Le module de division 22 comprend des blocs DSP3, DSP4 et DSP5 mettant en oeuvre une deuxième itération selon la relation Math 2. Le bloc DSP3 comprend un multiplicateur MUL3 recevant le signal Amp_mantissa et le signal $X_1$ et fournissant un signal Amp*$X_1$ égal au produit du signal Amp_mantissa et du signal $X_1$. Le bloc DSP4 comprend un multiplicateur MUL4 recevant le signal $X_1$ et le signal Dur_mantissa et fournissant le produit du signal $X_1$ et du signal Dur_mantissa et comprenant un soustracteur SOUS4 recevant le signal fourni par le multiplicateur MUL4 et le chiffre 2 et fournissant la différence entre le chiffre 2 et le signal fourni par le multiplicateur MUL4. Le bloc DSP5 comprend un multiplicateur MUL5 recevant le signal Amp*X1 et le signal fourni par le soustracteur SOUS4 et fournissant le signal Amp*X2 égal au produit du signal $X_2$ et du signal Amp_mantissa.

Le module de division 22 comprend un soustracteur 104 qui reçoit le paramètre brut Start_val et le paramètre brut End_val et qui détermine une donnée Amp égale à la différence entre le paramètre brut End_val et le paramètre brut Start_val. Le module de division 22 comprend un module 106 qui détermine si la donnée Amplitude est positive et un module 108 qui fournit alors le bit Amp_exponant de poids le plus significatif de la donnée Amplitude et un module 110 qui détermine si la donnée Amplitude est négative et un module 112 qui fournit alors le bit Amp_exponant de poids le plus significatif de la donnée Amplitude. Le module de division 22 comprend un module 114 qui reçoit la donnée Amplitude et fournit un signal Amp_mantissa égal à la donnée Amplitude dont les bits ont été décalées d'un nombre de position égal à 13-Amp-exponant vers le bit de poids le plus significatif. Le signal Amp_mantissa correspond donc à la mantisse de la donnée Amplitude. Le signal Amp_mantissa est ainsi normalisé entre 0,5 et 1.

Le module de division 22 comprend un additionneur ADD1 qui reçoit le signal Amp_exponant, le chiffre 3, et le signal Dur_exponant et fournit un signal Coeff_exponant égal à la somme entre le signal Amp_exponant, le chiffre 3, diminuée du signal Dur_exponant.

Le module de division 22 comprend un module 116 qui reçoit le signal Amp*$X_2$ et le signal Coeff_exponant et fournit un signal Coeff_mantissa.

Le module de division 22 comprend un automate fini 118. Le rôle de l'automate fini 118 est de fournir les adresses d'écriture de la mémoire de données 30 pour l'écriture des paramètres de données Coeff_mantissa, Coeff_exponant, Start_val, et Rest dans la mémoire de données 30, les paramètres de données Rest étant fournis par le module de calcul de durée 24. L'automate fini 118 comprend deux états INIT_B et RUN_B. A l'état INIT_B, l'automate fini 118 est au repos. Le passage de l'état INI_B à l'état START_B est réalisé lorsque l'automate fini 21 met un bit start_B à la valeur logique "1". A l'état RUN_B, l'automate fini 118 reçoit l'adresse start_adresse de la mémoire de données 30 à laquelle doit débuter l'écriture des paramètres de données Coeff_mantissa, Coeff_exponant, et Start_val dans la mémoire de données 30, et détermine les adresses d'écriture write address successives de la mémoire de données 30 auxquelles sont écrits les paramètres de données Coeff_mantissa, Coeff_exponant, Start_val, et Rest dans la mémoire de données 30 au fur et à mesure de leur fourniture. Le passage de l'état RUN_B à l'état INI_B est réalisé lorsque l'automate fini 21 met le bit start_B à la valeur logique "0".

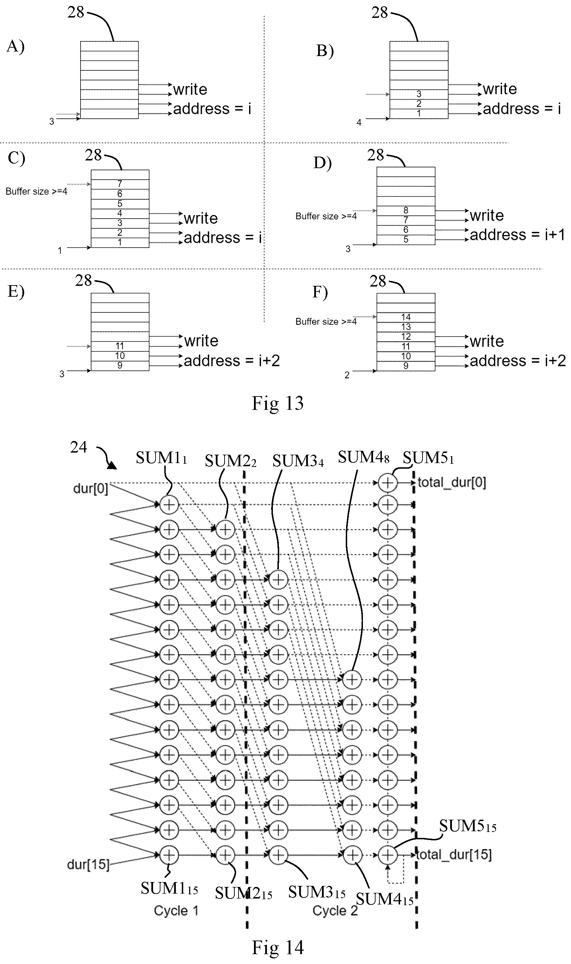

La figure 13 illustre un mode de réalisation d'un procédé de fonctionnement du module de réorganisation 28. Le fonctionnement du module de réorganisation 28 requiert deux cycles matériel. Le module de réorganisation 28 reçoit les paramètres de contrôle Cycles et Index du module de fusion 26 et les stocke dans une mémoire temporaire fonctionnant selon la méthode du premier entré, premier sorti. A chaque cycle matériel, le module de réorganisation 28 écrit dans la mémoire de contrôle 32 les quatre premières entrés de la mémoire temporaire. Lorsque le nombre de données stockées dans la mémoire du module de réorganisation 28 dépasse un seuil Buffer size, alors le nombre Buffer size de données vide les quatre premières entrés de la mémoire temporaire et décale de quatre positions les autres entrées de la mémoire temporaire, et l'adresse d'écriture write address de la mémoire 32 est incrémentée. A titre d'exemple, le seuil Buffer size est égal à 4. A titre d'exemple, à l'étape A), le module de réorganisation 28 reçoit trois nouvelles données. Les trois nouvelles données 1, 2, et 3 sont représentées stockées en mémoire à l'étape B). Le module de réorganisation 28 effectue une opération d'écriture des données 1, 2, et 3 dans la mémoire de contrôle 32 avec l'adresse d'écriture write address égale à i. En outre, à l'étape B), le module de réorganisation 28 reçoit quatre nouvelles données. Les quatre nouvelles données 4, 5, 6, et 7 sont représentées stockées en mémoire à l'étape C). Le module de réorganisation 28 effectue une opération d'écriture des données 1, 2, 3, et 4 dans la mémoire de contrôle 32 avec l'adresse d'écriture write address égale à i. Comme le nombre de données stockées est supérieur à 4 à l'étape C), le module de réorganisation 28 supprime les données 1, 2, 3, et 4 comme cela apparaît à l'étape D) et décale les données 5, 6, 7 de quatre positions et l'adresse d'écriture write address est incrémentée d'une unité. En outre, à l'étape C), le module de réorganisation 28 reçoit une nouvelle donnée. La nouvelle donnée 8 est représentée stockée en mémoire à l'étape D). Le module de réorganisation 28 effectue une opération d'écriture des données 5, 6, 7, et 8 dans la mémoire de contrôle 32 avec l'adresse d'écriture write address égale à i+1. Comme le nombre de données stockées est supérieur à 4 à l'étape D), le module de réorganisation 28 supprime les données 5, 6, 7, et 8 dans la mémoire de contrôle 32 comme cela apparaît à l'étape E). En outre, à l'étape D), le module de réorganisation 28 reçoit trois nouvelles données. Les trois nouvelles données 9, 10, et 11 sont représentées stockées en mémoire à l'étape E). Le module de réorganisation 28 effectue une opération d'écriture des données 9, 10, et 11 dans la mémoire de contrôle 32 avec l'adresse d'écriture write address égale à i+2. En outre, à l'étape E), le module de réorganisation 28 reçoit trois nouvelles données. Les trois nouvelles données 12, 13, et 14 sont représentées stockées en mémoire à l'étape F). Le module de réorganisation 28 effectue une opération d'écriture des données 9, 10, 11, et 12 dans la mémoire de contrôle 32 avec l'adresse d'écriture write address égale à i+2.

La figure 14 représente un mode de réalisation du module de calcul de durée 24 configuré pour déterminer la durée totale total_dur de la forme d'onde. Selon un mode de réalisation, le module de calcul de durée 24 a une structure de Kogge-Stone. Selon un mode de réalisation, le module de calcul de durée 24 reçoit Nout paramètres bruts Duration, notés en figure 14 dur[0] à dur[Nout], de Nout rampes successives et détermine Nout données de durée total_dur[0] à total_dur[Nout-1]. Selon un mode de réalisation, chaque paramètre brut dur[0] à dur[Nout] comprend 14 bits et chaque donnée total_dur[0] à total_dur[Nout-1] comprend 14+log(Nout) bits. A titre d'exemple, en figure 14, Nout est égal à 16.

Le module de calcul de durée 24 reçoit les données bruts Duration des rampes codées sur 14 bits, dur[0] à dur[15]. Le module de calcul de durée 24 comprend des premiers sommateurs $SUM1_j$, j étant un nombre entier variant de 1 à 15. Chaque sommateur $SUM1_j$, j variant de 1 à 15, reçoit les données dur[j-1] et dur[j] et détermine la donnée s1[j] égale à la somme entre les données dur[j-1] et dur[j]. Le module de calcul de durée 24 comprend en outre des deuxièmes sommateurs $SUM2_j$, j étant un nombre entier variant de 2 à 15. Chaque sommateur $SUM2_j$, j variant de 2 à 15, reçoit les données sli[j-2] et s1[j], la donnée s1[0] étant égale à la donnée dur[0]. Chaque sommateur $SUM2_j$, j variant de 2 à 15, détermine la donnée s2[j] égale à la somme entre les données s1[j-2] et s1[j] et donc égal à la somme entre les données dur[j-2] à dur[j]. Le module de calcul de durée 24 comprend en outre des troisièmes sommateurs $SUM3_j$, j étant un nombre entier variant de 4 à 15. Chaque sommateur $SUM3_j$, j variant de 4 à 15, reçoit les données s2[j-4] et s2[j], le bit s2[0] étant égale à dur[0] et le bit s2[1] étant égale au bit s1[1]. Chaque sommateur $SUM3_j$, j variant de 4 à 15, détermine la donnée s3[j] égale à la somme entre les données s2[j-4] et s2[j] et donc égal à la somme entre les données dur[j-5] à dur[j]. Le module de calcul de durée 24 comprend en outre des quatrièmes sommateurs $SUM4_j$, j étant un nombre entier variant de 8 à 15. Chaque sommateur $SUM4_j$, j variant de 8 à 15, reçoit les données s3[j-8] et s3[j], le bit s3[0] étant égale à dur[0], le bit s3[1] étant égale au bit s1[1], le bit s3[2] étant égale au bit s2[2], et le bit s3[3] étant égale au bit s2[3]. Chaque sommateur $SUM4_j$, j variant de 8 à 15, détermine la donnée s4[j] égale à la somme entre les données s3[j-8] et s3[j] et donc égal à la somme entre les données dur[j-8] à dur[j]. Le module de calcul de durée 24 comprend en outre des cinquièmes sommateurs $SUM5_j$, j étant un nombre entier variant de 0 à 15. Chaque sommateur $SUM5_j$, j variant de 1 à 15, détermine la donnée total_dur[j] égale à la somme entre le bit s4[j] et la valeur précédente de total_dur[j].

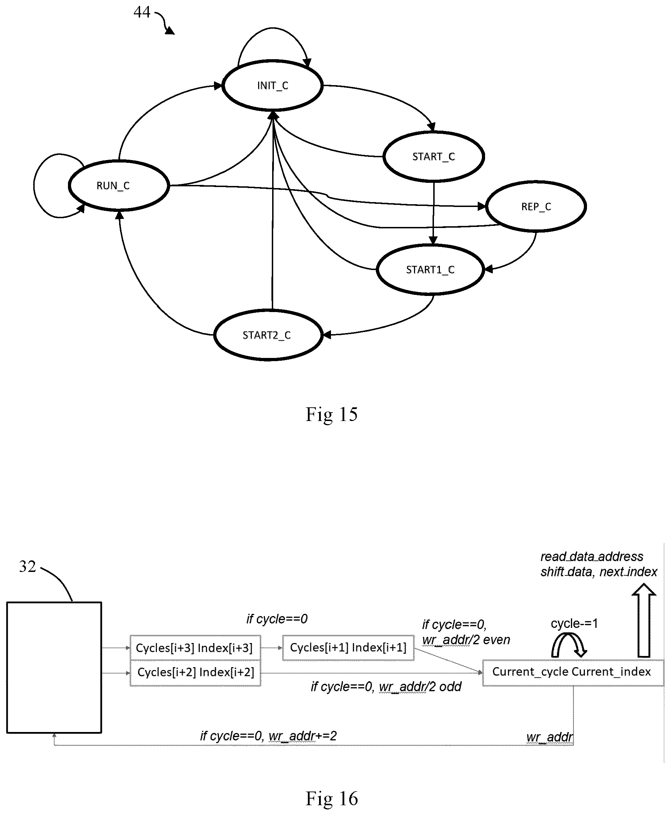

La figure 15 illustre un mode de réalisation du module de recherche 44 lorsqu'il correspond à un automate fini. Le module de recherche 44 reçoit des instructions de l'utilisateur tels que le démarrage ou l'arrêt de l'exécution d'une forme d'onde. Le module de recherche 44 a pour rôle, lors de l'exécution d'une forme d'onde, de déterminer les adresses de lecture de la mémoire de données 30 dans laquelle sont stockés les paramètres de données et les adresses de lecture de la mémoire de contrôle 32 dans laquelle sont stockés les paramètres de contrôle.

Le module de recherche 44 comprend six états INIT_C, START_C, START1_C, START2_C, RUN_C, et REP_C.

A l'état INIT_C, le module de recherche 44 est au repos. Le passage de l'état INI_C à l'état START_C est réalisé lorsqu'un bit update est mis à la valeur logique "1" par un système externe au circuit électronique 10. Ceci correspond à une instruction de démarrage de l'exécution d'une forme d'onde. Le démarrage de la forme d'onde coûte 4 cycles matériel.

A l'état START_C, le module de recherche 44 lit des paramètres d'exécution de la forme d'onde dans la mémoire 34, comprenant notamment la taille (paramètre Taille_waveform) de la forme d'onde et le fait que la forme d'onde doit être exécutée de façon répétée ou non (paramètre Repeat). Le module de recherche 44 lit en outre, dans la mémoire 34, l'adresse de lecture de la mémoire de données 30 à laquelle débuter la lecture des paramètres de données de la forme d'onde. Le module de recherche 44 met alors un bit started à la valeur logique "1", ce qui entraîne le passage de l'état START_C à l'état START1_C.

A l'état START1_C, le module de recherche 44 effectue une lecture des paramètres de données de la forme d'onde, dans la mémoire de donées 30, à l'adresse de lecture obtenue à l'état START_C, , et une lecture des paramètres de contrôle de la forme d'onde, dans la mémoire de contrôle 32, à l'adresse de lecture obtenue à l'état START_C. Le module de recherche 44 met alors un bit enb_data à la valeur logique "1", ce qui entraîne le passage de l'état START1_C à l'état START2_C.

A l'état START2_C, le module de recherche 44 attend que l'étape de lecture initiée à l'état START1_C se soit déroulée correctement. Le passage de l'état START_2C à l'état RUN_C est réalisé lorsqu'un bit first_next est mis à la valeur logique "1" par le module de recherche 44.

A l'état RUN_C, le module de recherche 44 détermine les prochaines adresses de lecture read_data_address des paramètres de données dans la mémoire de données 30 et les prochaines adresses de lecture wr_addr des paramètres de contrôle dans la mémoire de contrôle 32. Le module de recherche 44 peut en outre fournir une donnée shift _dataet une donnée next_index utilisée par le module d'interprétation 42 comme cela est décrit par la suite.

Le passage de l'état RUN_C à l'état REP_C est réalisé lorsque le module de recherche 44 a lu les derniers paramètres de données et paramètres de contrôle de la forme d'onde et que la forme d'onde doit être exécutée de façon répétée. Le passage de l'état RUN_C à l'état INIT_C est réalisé lorsque le module de recherche 44 a lu les derniers paramètres de données et paramètres de contrôle de la forme d'onde et que la forme d'onde doit être exécutée une seule fois.

A l'état REP_C, le module de recherche 44 réinitialise l'exécution de la forme d'onde. Le module de recherche 44 passe alors à l'état START1_C comme lors de la première exécution de la forme d'onde.

Le passage de l'état START_C, START1_C, START2_C, RUN_C, et REP_C à l'état INIT_C est réalisé lorsqu'un bit stop est mis à la valeur logique "1" par un système externe au circuit électronique 10. Ceci correspond à une instruction d'arrêt de l'exécution d'une forme d'onde.

La figure 16 illustre un mode de réalisation d'un procédé de lecture des paramètres de contrôle dans la mémoire de contrôle 32 par le module de recherche 44 à l'état RUN_C.

Le module de recherche 44 doit être capable d'analyser et de lire une ligne de paramètres de contrôle dans la mémoire de contrôle 32 par cycle matériel. En effet, un groupe de rampes peut ne durer qu'un seul cycle matériel. Il faut donc pouvoir déterminer la prochaine adresse de lecture dans la mémoire de données 30 en un cycle matériel pour traiter le cas où plusieurs groupes de ce type s'enchaînent. Selon un mode de réalisation, le changement d'une adresse de lecture et la récupération des données peuvent coûter plus d'un cycle matériel, par exemple deux cycles matériel. Ainsi le module de recherche 44 doit pouvoir avoir accès "en avance" aux informations de la ligne de contrôle suivante. Selon un mode de réalisation, le module de recherche 44 lit les lignes deux par deux dans la mémoire de contrôle 32 et stocke, dans une mémoire tampon, les lignes impaires (Cycles[i+1] Index[i+1]). L'adresse de lecture wr_addr dans la mémoire de contrôle 32 est donc incrémentée deux par deux. De façon générale, selon la latence du module de recherche 44, une lecture de plus de deux lignes de la mémoire de contrôle 32 peut être prévue.

Lorsque le groupe de rampes se termine (ce qui correspond à la donnée Current_cycle égale à 0), le module de recherche 44 met à jour les adresses de lecture read_data_address, envoie au module d'interprétation 42 le prochain décalage de réalignement shift _dataainsi que la taille du groupe de rampe next_index pour gérer la transition vers le prochain groupe de rampe.

A titre d'exemple, le module de recherche 44 met la donnée Current_cycle égale au paramètre de contrôle Cycles[i] et met la donnée Current_Index égale au paramètre de contrôle Index[i] lus à l'adresse wr_addr de la mémoire 32, et conserve en mémoire les paramètres de contrôle Cycles[i+1] Index[i+1] lus à l'adresse wr_addr+1 de la mémoire 32. A chaque cycle matériel, la donnée Current_cycle est diminuée de 1 (cycle-=1). Lorsque la valeur de la donnée Current_cycle est égale à 0 (if cycle==0) et que les paramètres de contrôle Cycles[i+1] Index[i+1] n'ont pas encore été utilisés (wr_addr/2 even), le module de recherche 44 met la donnée Current_cycle égale au paramètre de contrôle Cycles[i+1] et met la donnée Current_Index égale au paramètre de contrôle Index[i+1] lus à l'adresse wr_addr+1 de la mémoire 32. Lorsque la valeur de la donnée Current_cycle est égale à 0 (if cycle==0) et que les paramètres de contrôle Cycles[i+1] Index[i+1] ont déjà encore été utilisé (wr_addr/2 odd), l'adresse de lecture wr_addr dans la mémoire de contrôle 32 est incrémentée de 2 (wr_addr+=2), et les deux lignes suivants (Cycles[i+2] Index[i+2] et Cycles[i+3] Index [i+3]) sont lues dans la mémoire 32.

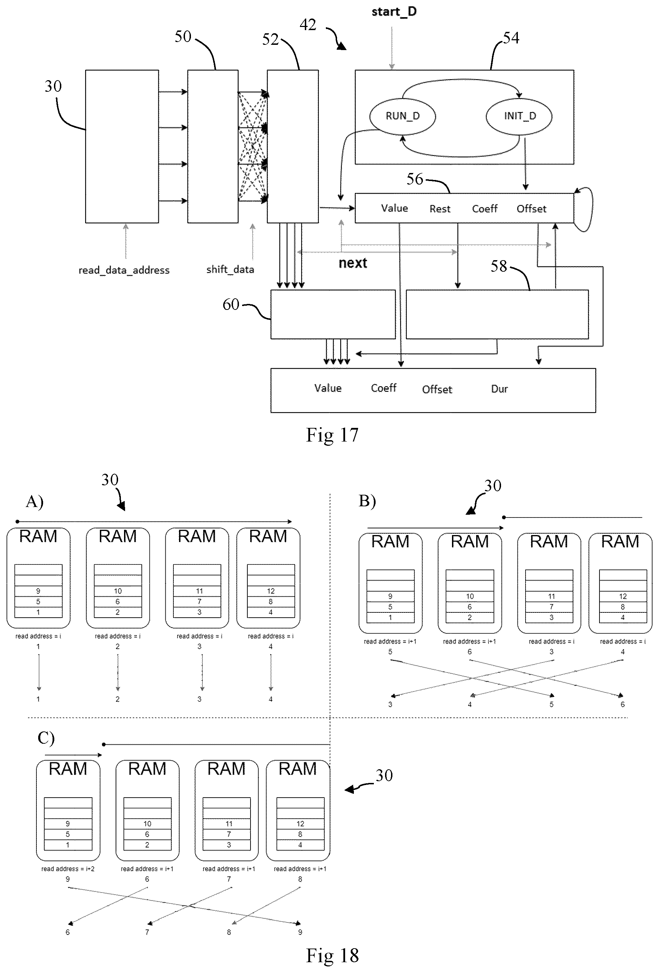

La figure 17 représente un mode de réalisation du module d'interprétation 42.

Le module d'interprétation 42 comprend :

- une première mémoire tampon 50 ;
- une deuxième mémoire tampon 52 ;
- un automate fini 54 ;
- une mémoire de traitement 56 ;
- un registre d'indice 58 ; et

- une mémoire de sortie 60.

L'automate fini 54 comprend deux états RUN_D et INIT_D. A l'état INIT_D, l'automate fini 54 fournit des valeurs par défaut pour les données Value, Rest, Coeff, Offset. Le passage de l'état INI_D à l'état RUN_D est réalisé lorsque l'automate fini 44 met un bit start_D à la valeur logique "1". A l'état RUN_D, l'automate fini 54 détermine Nout points à chaque cycle matériel. Le passage de l'état RUN_D à l'état INIT_D est réalisé lorsque l'automate fini 44 met le bit start_D à la valeur logique "0".

La mémoire de données 30 est implémentée comme Nout blocs mémoire en parallèle, de ce fait, car nous lisons avec une fenêtre glissante non alignée avec Nout, il faut réaligner les données. C'est le module de recherche 44 qui détermine la valeur du décalage shift_datanécessaire au réalignement, décrit plus en détail par la suite.

A la lecture d'une nouvelle rampe au début d'une nouveau cycle matériel, l'automate fini 54 lit les données Start_val, Coeff, et Rest stockées dans la deuxième mémoire tampon 52 et les stocke dans la mémoire de traitement 56. La donnée Start_val sur 14 bits de la deuxième mémoire tampon 52 est enregistrée sur 28 bits dans la mémoire de traitement 56 dans la donnée Value. Le paramètre de données Coeff sur 14 bits de la deuxième mémoire tampon 52 est enregistré sur 28 bits à virgule fixe dans la mémoire de traitement 56. Les Nout lignes de la première mémoire tampon 50 et de deuxième mémoire tampon 52 sont alors mises à jour.

A chaque cycle matériel, l'automate fini 54 détermine Nout points qui sont enregistrés dans la mémoire de sortie 60. Chaque point correspond à un ensemble de données comprenant la donnée Value, le paramètre de données Coeff, la donnée Dur, et la donnée Offset. Les Nout points enregistrés dans la mémoire de sortie 60 sont lus par le module d'interpolation 44 pour fournir Nout valeurs numériques du signal numérique Sn, selon la relation Math 1 décrite précédemment. La donnée Dur correspond à la durée par rapport à l'instant de la valeur Value et peut donc varier de 0 à (Nout-1)*Tdac. La donnée Offset correspond à un décalage de durée et est égale à un multiple de Tdac (éventuellement 0).

Lorsque le cycle matériel est fini mais que la rampe n'est pas achevée, la valeur Value est mise à jour en y ajoutant la donnée Nout*Coeff. Pour ne pas devoir réaliser de multiplication, ceci peut être réalisé en décalant les bits de la donnée Coeff vers la gauche Nout fois et en ajoutant la valeur obtenue à la donnée Value. L'automate fini 54 va réaliser cette action tant que la première rampe du groupe n'est pas épuisée.

Lorsque la première rampe est épuisée, le système va commencer à remplir les Nout points avec le nombre Rest de points de la première rampe. Connaissant la taille du groupe de rampe, il va aller chercher les rampes nécessaires pour compléter le cycle. Chaque rampe a sa durée encodée sur la donnée Rest. Ainsi le module d'interprétation 42 va concaténer les Nout points nécessaires pour compléter le cycle matériel. Il peut alors ensuite aller chercher la première rampe du prochain groupe de rampes, et calculer la valeur Offset (partie de la rampe joué pendant le groupe précédent). Cette valeur Offset évite une multiplication supplémentaire pour initialiser la valeur de la première rampe du prochain groupe de rampe. Il y a une exception à gérer lorsque le groupe finit aligné avec un cycle matériel. Il n'y a alors pas de décalage sur la première rampe du prochain groupe de rampe, ce qui correspond à la donnée Offset égale à 0.

Le module d'interprétation 42 gère aussi la fin d'une forme d'onde. Lorsqu'il n'y a plus de points à jouer, le module d'interprétation 42 va garder le dernier point connu et le jouer de façon continue.

Même si le paramètre de données Coeff est enregistré sur 28 bits dans la mémoire de sortie 60, il peut être avantageux que le module d'interpolation 44 ne lise que les 14 bits de poids le plus fort du paramètre de données Coeff dans la mémoire de sortie 60, par exemple pour être compatible avec la fréquence fhard. Lorsque le paramètre de données Coeff à enregistrer dans la mémoire de sortie 60 est compris strictement entre -1 et 0, celui-ci doit être arrondi à 0. Lorsque le paramètre de données Coeff est négatif plus grand que -1, ces 14 bits de poids le plus fort sont arrondis à -1 même si celui-ci est en réalité très proche de 0. Pour éviter des effets de rebonds (car la valeur dans le buffer elle est bien mis à jour avec le coefficient sur 28 bits) le paramètre de données Coeff est donc plutôt arrondi à 0 dans ce cas.

A titre d'exemple, au quatrième cycle matériel lors de l'exécution de la forme d'onde du tableau Table 7 décrit précédemment, le module de recherche 44 indique au module d'interprétation 42 que deux rampes supplémentaires seront nécessaires pour finir le cycle matériel en fournissant au module d'interprétation 42 la donnée next_index égale à la donnée Current_index du tableau Table 24 décrit précédemment. Le module d'interprétation 42 lit donc les paramètres de données des deux rampes suivantes dans le tableau Table 23 décrit précédemment. Avec les données stockées dans la mémoire de traitement 56, qui correspondent aux données du tableau Table 22 décrit précédemment, le module de traitement 42 détermine un ensemble de valeurs comprenant la donnée Value égale à 4192, la donnée Coeff égale à -1451, la donnée Offset égale à 1, et la donnée Dur égale à 0 puisque le paramètre de données Rest est égal à 1. Puis, comme le paramètre de données Rest de la première rampe suivante est égal à 2 (première ligne du tableau Table 23), le module de traitement 42 détermine que la première rampe suivante n'est jouée qu'une seule fois et détermine un ensemble de valeurs un ensemble de valeurs comprenant la donnée Value égale à 1290, la donnée Coeff égale à 1612, la donnée Offset égale à 0, et la donnée Dur égale à 0. Comme le paramètre de données Rest de la deuxième rampe suivante est égal à 1 (deuxième ligne du tableau Table 23), le module de traitement 42 détermine que la deuxième rampe suivante est jouée jusqu'à la fin du quatrième cycle matériel et également au cycle suivant. Au quatrième cycle, le module de traitement 42 détermine donc deux ensembles de valeurs, chacun comprenant la donnée Value égale à 2902, la donnée Coeff égale à -414,57, la donnée Offset égale à 0, et la donnée Dur respectivement égale à 0 et à Tdac. Pour le cinquième cycle qui va suivre, le module de traitement 42 met à jour les données de la mémoire de traitement 56, qui correspondent aux données du tableau Table 25 décrit précédemment. Comme la rampe définie par les données de la mémoire de traitement 56 a déjà été jouée deux fois, le module d'interprétation a mis la donnée Offset à 2.

La figure 18 illustre un mode de réalisation d'un procédé de fonctionnement de la première mémoire tampon 50 et de la deuxième mémoire tampon 52. En figure 18, Nout est pris égal à 4, de sorte que la mémoire de données est implémentée comme 4 blocs mémoire en parallèle. Comme le module d'interprétation 42 lit avec une fenêtre glissante non alignée avec les 4 blocs mémoire, il faut réaligner les données. C'est le module de recherche 44 qui détermine la valeur du décalage shift _datanécessaire au réalignement. Dans le cas A), la valeur de décalage est égale à 0. Dans le cas B), la valeur de décalage est égale à 2. Dans le cas C), la valeur de décalage est égale à 3.

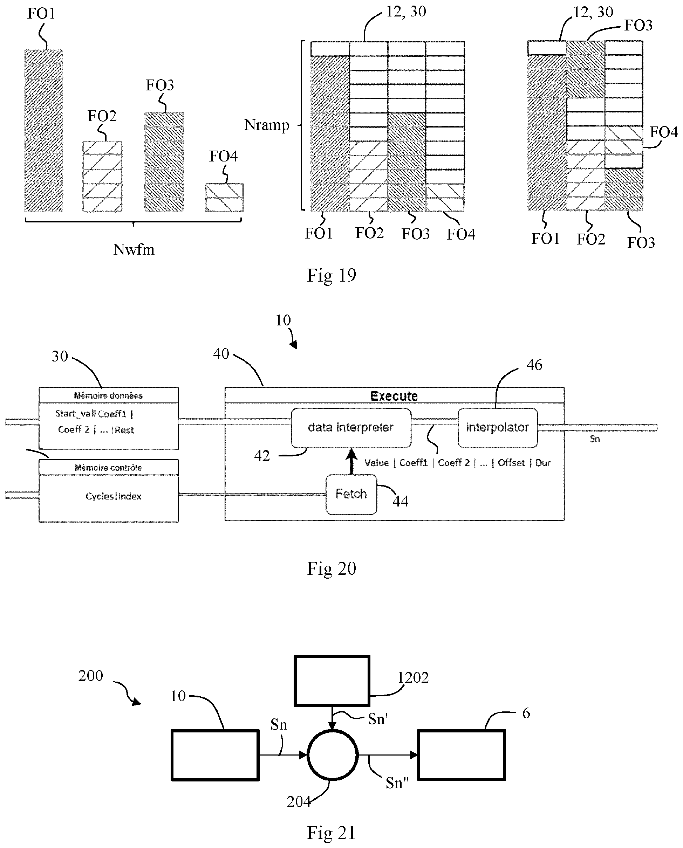

La figure 19 illustre un mode de réalisation d'un procédé de gestion des mémoires 30 et 32. On appelle Nwfm le nombre de forme d'onde utilisable et Nramp le nombre maximal possible de rampes par forme d'onde. En partie gauhe de la figure 19, on a représenté très schématiquement quatre formes d'onde FO1, FO2, FO3, FO4 que l'on souhaite pouvoir jouer. En partie centrale de la figure 19, on a représenté la mémoire 12, 30 dans laquelle les données des quatre formes d'onde FO1, FO2, FO3, FO4 sont stockés de façon non optimale. La taille de la mémoire 12, 30 est alors égale au produit Nwfm*Nramp. En partie centrale de la figure 19, on a représenté la mémoire 12, 30 dans laquelle les données des quatre formes d'onde FO1, FO2, FO3, FO4 sont stockées de façon optimale. La taille de la mémoire 12, 30 peut alors être strictement inférieure au produit Nwfm*Nramp.

Dans les modes de réalisation décrits précédemment, le circuit de décodage 20 et le circuit d'exécution 40 sont chacun réalisés par un circuit électronique dédié. Selon un autre mode de réalisation, seul le circuit d'exécution 40 est réalisé par un circuit électronique dédié et le circuit de décodage 20 comprend un processeur, par exemple un microprocesseur ou un microcontrôleur, configuré pour exécuter des instructions d'un programme d'ordinateur stockées dans une mémoire.

Les modes de réalisation décrits précédemment concernent des formes d'onde comprenant des rampes linéaires. Selon un autre mode de réalisation, chaque rampe de la forme d'onde peut suivre une fonction polynomiale P(x) selon la relation suivante :

[Math 5]

$$P(x) = Start\_value + Coeff1*x + Coeff2*x^2 + \cdots + CoeffD*x^D$$

où D est le degré du polynôme et les coefficients Coeffj, j variant de 1 à **D,** sont les coefficients du polynôme. Lorsque le degré du polynôme est égal à **1,** la rampe correspond à une rampe linéaire. Lorsque le degré du polynôme est supérieur ou égal à **2,** la rampe correspond à une rampe non linéaire.

La figure 20 représente, de façon schématique, un autre mode de réalisation du circuit électronique 10 configuré pour exécuter une forme d'onde dont chaque rampe suit la relation Math 5 indiquée précédemment. Dans ce mode de réalisation, les paramètres de données stockés dans la mémoire 30 comprennent, pour chaque rampe, les paramètres de données Start_val et Rest décrits précédemment et, en outre, les coefficients Coeffj, j variant de 1 à **D.** Le module d'interprétation 42 et le module de recherche 44 peuvent avoir la même structure que celle décrite précédemment, à la différence que les données traitées sont plus importantes étant donné qu'il y a plusieurs coefficients Coeff. Le module d'interpolation 46 fournit chaque valeur numérique du signal Sn à partir des données Value, Dur, Offset, Coeff1, ... CoeffD fournies par le module d'interprétation 42 selon la relation suivante.

[Math 6]

$$P(x) = Start\_value + Coeff1*x + Coeff2*x^2 + \cdots + CoeffD*x^D$$

En particulier, lorsque le module d'interpolation 46 est réalisé par un circuit FPGA, le calcul d'une valeur numérique par le module d'interpolation 46 peut prendre D+1 cycles matériel et nécessiter D multiplicateurs.

Dans les modes de réalisation décrits précédemment, le circuit de décodage 20 est configuré pour fournir, à chaque cycle d'horloge matériel, les paramètres de données et les paramètres de contrôle de Nout rampes successives de la forme d'onde et le circuit d'exécution 40 est configuré pour fournir, à chaque cycle d'horloge matériel, Nout valeurs numériques du signal numérique Sn. Selon un autre mode de réalisation, le circuit de décodage 20 est configuré pour fournir, à chaque cycle d'horloge matériel, les paramètres de données et les paramètres de contrôle de Nout1 rampes successives de la forme d'onde et le circuit d'exécution 40 est configuré pour fournir, à chaque cycle d'horloge matériel, Nout2 valeurs numériques du signal numérique Sn, Nout1 et Nout2 étant des nombres entiers différents. En particulier, Nout1 peut être inférieur strictement à Nout2. Ceci permet de façon avantageuse de simplifier la réalisation du circuit de décodage 20.

Le signal numérique Sn fourni par le circuit électronique 10 peut être modifié avant sa transmission au convertisseur numérique-analogique 6.

La figure 21 représente un mode de réalisation d'un système 200 de fourniture d'un signal numérique Sn". Le système 200 comprend le circuit électronique 10, représenté sur le figure 9, qui fournit le signal numérique Sn et un circuit 202 configuré pour fournir un signal numérique Sn'. Le système 200 comprend, en outre, un circuit 204, par exemple un sommateur, qui reçoit les signaux numériques Sn et Sn' et fournit le signal numérique Sn", par exemple égal à la somme des signaux numériques Sn et Sn'.

Des essais ont été réalisés. Pour ces essais, le circuit électronique 10 est réalisé par un circuit FPGA. Le paramètre Nwfm est égal à 32, le paramètre Nramp est égale à 256. La taille de chaque mémoire 12, 30, et 32 est égale à 8192.

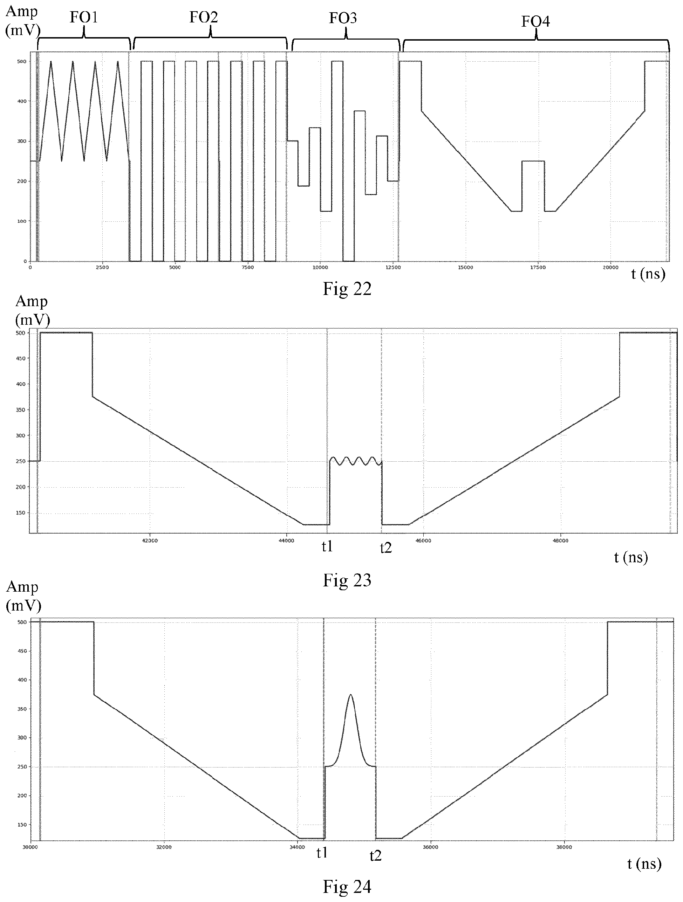

La figure 22 est un chronogramme de plusieurs quatre formes d'onde FO1, FO2, FO3, et FO4 successives.

La figure 23 est un chronogramme de la quatrième forme d'onde FO4 de la figure 22 à laquelle a été ajouté un signal numérique d'une forme d'onde sinusoïdale entre les instants t1 et t2.

La figure 24 est un chronogramme de la quatrième forme d'onde FO4 de la figure 22 à laquelle a été ajouté un signal numérique d'une forme d'onde de type gaussienne entre les instants t1 et t2.

Divers modes de réalisation et variantes ont été décrits. La personne du métier comprendra que certaines caractéristiques de ces divers modes de réalisation et variantes pourraient être combinées, et d'autres variantes apparaîtront à la personne du métier sans sortir du cadre des revendications en annexe.

Enfin, la mise en oeuvre pratique des modes de réalisation et variantes décrits est à la portée de la personne du métier à partir des indications fonctionnelles données ci-dessus.

## Revendications

1. Circuit électronique (10) de fourniture d'un signal numérique (Sn), un signal analogique obtenu par conversion numérique-analogique du signal numérique comprenant une succession de rampes, le circuit électronique étant cadencé par un signal d'horloge, le circuit électronique étant configuré pour fournir un nombre Nout de valeurs numériques successives du signal numérique à chaque cycle du signal d'horloge, Nout étant strictement supérieur à 1, le circuit électronique comprenant une première mémoire (30) dans laquelle sont stockées, pour chaque rampe, des premières données comprenant une valeur de début de la rampe, la pente de la rampe, et une durée restante de la rampe dans le dernier cycle du signal d'horloge dans lequel s'étend la rampe, et une deuxième mémoire (32) dans laquelle sont stockées des deuxièmes données relatives aux nombres de cycles du signal d'horloge sur lesquels s'étendent certaines des rampes, et un premier circuit (40) configuré pour lire dans la première mémoire les premières données relatives à plusieurs rampes successives et dans la deuxième mémoire les deuxièmes données associées auxdites plusieurs rampes successives, et pour fournir lesdites valeurs numériques à partir des premières et deuxièmes données lues.

2. Circuit électronique selon la revendication 1, dans lequel le premier circuit (40) est configuré pour lire en parallèle dans la première mémoire (30) les premières données relatives à Nout rampes successives, pour lire dans la deuxième mémoire les deuxièmes données associées auxdites Nout rampes successives, et pour fournir, à un cycle du signal d'horloge, Nout valeurs numériques du signal numérique faisant partie d'une à Nout rampes parmi lesdites Nout rampes

3. Circuit électronique selon la revendication 2, dans lequel le premier circuit (40) comprend Nout circuits d'interpolation (46) en parallèle, chaque circuit d'interpolation étant configuré pour calculer, à un cycle du signal d'horloge, l'une des Nout valeurs numériques du signal numérique faisant partie d'une à Nout rampes parmi lesdites Nout rampes successives.

4. Circuit électronique selon d'une des quelconque des revendications 1 à 3, dans laquelle les premières données stockées dans la première mémoire (30) comprennent, pour chaque rampe, des coefficients d'un polynôme de degré supérieur ou égal à 2, la pente de la rampe étant le coefficient de degré 1 du polynôme, le premier circuit (40) étant configuré pour fournir lesdites valeurs numériques de rampes correspondant à des fonctions polynomiales.

5. Circuit électronique selon l'une quelconque des revendications 1 à 4, dans lequel Nout est une puissance de deux, en particulier 2, 4, 8, ou 16.

6. Circuit électronique selon l'une quelconque des revendications 1 à 5, dans lequel le premier circuit (40) est configuré pour lire, dans la première mémoire (30), simultanément les premières données de Nout rampes successives.

7. Circuit électronique selon l'une quelconque des revendications 1 à 6, dans lequel le premier circuit (40) est configuré pour lire, dans la deuxième mémoire (32), simultanément les deuxième données de Nout rampes successives.

8. Circuit électronique selon l'une quelconque des revendications 1 à 7, dans lequel le premier circuit (40) comprend un premier module (42) configuré pour fournir, à chaque cycle du signal d'horloge, des ensembles de données, chaque ensemble comprenant une valeur de début de rampe, la pente de la rampe, et un délai, le délai variant d'un ensemble à l'autre, et un deuxième module (44) configuré, pour chaque ensemble, à fournir une valeur numérique du signal numérique égale à la somme de la valeur de début de la rampe et du produit de la pente de la rampe et du délai.

9. Circuit électronique selon l'une quelconque des revendications 1 à 8, dans lequel la première mémoire (30) comprend Nout blocs mémoire en parallèle.

10. Circuit électronique selon l'une quelconque des revendications 1 à 9, comprenant une troisième mémoire (12) dans laquelle sont stockées, pour chaque rampe de la succession de rampes, des troisièmes données comprenant la valeur de début de la rampe, la valeur de fin de la rampe, et la durée de la rampe, le circuit électronique comprenant en outre un deuxième circuit (20) configuré pour fournir, à partir des troisièmes données, les premières données et les deuxièmes données, et pour écrire les premières données dans la première mémoire (30) et pour écrire les deuxièmes données dans la deuxième mémoire (32).

11. Circuit électronique selon la revendication 10, dans lequel le deuxième circuit (20) est configuré pour traiter les troisièmes données par lots de Nout rampes successives.

12. Circuit électronique selon la revendication 10 ou 11, dans lequel le deuxième circuit (20) comprend un troisième module (22) configuré pour déterminer, pour chaque rampe, la pente de la rampe, et un quatrième module (24) configuré pour déterminer la durée totale écoulée depuis le début de la succession de rampes jusqu'à la fin de la rampe et le nombre de cycles du signal d'horloge contenu dans ladite durée totale.

13. Système (10) comprenant le circuit électronique selon l'une quelconque des revendications 1 à 12, un convertisseur numérique-analogique (6) configuré pour convertir le signal numérique (Sn) en un signal analogique (Sa), et des cellules de stockage de bits quantiques (2) recevant le signal analogique.

14. Procédé de fourniture d'un signal numérique (Sn), un signal analogique obtenu par conversion numérique-analogique du signal numérique comprenant une succession de rampes, le procédé comprenant la fourniture, à chaque cycle d'un signal d'horloge, d'un nombre Nout de valeurs numériques successives du signal numérique, Nout étant strictement supérieur à 1, le procédé comprenant la fourniture d'une première mémoire (30) dans laquelle sont stockées, pour chaque rampe, des premières données comprenant une valeur de début de la rampe, la pente de la rampe, et une durée restante de la rampe dans le dernier cycle du signal d'horloge dans lequel s'étend la rampe, la fourniture d'une deuxième mémoire (32) dans laquelle sont stockées des deuxièmes données relatives aux nombres de cycles du signal d'horloge sur lesquels s'étendent certaines des rampes, la lecture, dans la première mémoire, des premières données relatives à plusieurs rampes successives et, dans la deuxième mémoire, des deuxièmes données associées auxdites plusieurs rampes successives, et la fourniture desdites valeurs numériques à partir des premières et deuxièmes données lues.

**Patentansprüche**

1. Elektronische Schaltung (10) zum Bereitstellen eines digitalen Signals (Sn), wobei ein analoges Signal, das durch Digital-Analog-Wandlung des digitalen Signals erhalten wird, eine Folge von Rampen aufweist, wobei die elektronische Schaltung durch ein Taktsignal getaktet wird, wobei die elektronische Schaltung konfiguriert ist zum Liefern einer Anzahl Nout von aufeinanderfolgenden digitalen Werten des digitalen Signals bei jedem Zyklus des Taktsignals, wobei Nout größer als 1 ist, wobei die elektronische Schaltung einen ersten Speicher (30) aufweist, in dem für jede Rampe erste Daten gespeichert sind, die einen Startwert der Rampe aufweisen, die Steigung der Rampe und eine verbleibende Dauer der Rampe im letzten Zyklus des Taktsignals, in dem sich die Rampe erstreckt, und einen zweiten Speicher (32) aufweist, in dem zweite Daten in Bezug auf die Anzahl der Zyklen des Taktsignals gespeichert sind, über die sich einige der Rampen erstrecken, und eine erste Schaltung (40), die konfiguriert ist zum Lesen, aus dem ersten Speicher, der ersten Daten in Bezug auf eine Vielzahl von aufeinanderfolgenden Rampen und, aus dem zweiten Speicher, der zweiten Daten, die mit der Vielzahl von aufeinanderfolgenden Rampen verknüpft sind, und zum Bereitstellen der digitalen Werte basierend auf den ersten und zweiten gelesenen Daten.

2. Elektronische Schaltung nach Anspruch 1, wobei die erste Schaltung (40) konfiguriert ist zum parallelen Lesen, aus dem ersten Speicher (30), der ersten Daten in Bezug auf Nout aufeinanderfolgende Rampen, zum Lesen, aus dem zweiten Speicher, der zweiten Daten, die mit den Nout aufeinanderfolgenden Rampen verknüpft sind, und zum Liefern, bei einem Zyklus des Taktsignals, von Nout digitalen Werten des digitalen Signals, die Teil von einer bis Nout Rampen unter den Nout Rampen sind.

3. Elektronische Schaltung nach Anspruch 2, wobei die erste Schaltung (40) Nout Interpolationsschaltungen (46) parallel aufweist, wobei jede Interpolationsschaltung konfiguriert ist zum Berechnen, bei einem Zyklus des Taktsignals, eines der Nout digitalen Werte des digitalen Signals, die Teil von einer bis Nout Rampen unter den Nout aufeinanderfolgenden Rampen sind.

4. Elektronische Schaltung nach einem der Ansprüche 1 bis 3, wobei die ersten Daten, die in dem ersten Speicher (30) gespeichert sind, für jede Rampe Koeffizienten eines Polynoms mit einem Grad größer oder gleich 2 aufweisen, wobei die Steigung der Rampe der Koeffizient des Grades 1 des Polynoms ist, wobei die erste Schaltung (40) konfiguriert ist zum Liefern der digitalen Werte der Rampen entsprechend zu Polynomfunktionen.

5. Elektronische Schaltung nach einem der Ansprüche 1 bis 4, wobei Nout eine Zweierpotenz ist, insbesondere 2, 4, 8 oder 16.

6. Elektronische Schaltung nach einem der Ansprüche 1 bis 5, wobei die erste Schaltung (40) konfiguriert ist zum gleichzeitigen Lesen, aus dem ersten Speicher (30), der ersten Daten von Nout aufeinanderfolgenden Rampen.

7. Elektronische Schaltung nach einem der Ansprüche 1 bis 6, wobei die erste Schaltung (40) konfiguriert ist zum gleichzeitigen Lesen, aus dem zweiten Speicher (32), der zweiten Daten von Nout aufeinanderfolgenden Rampen.

8. Elektronische Schaltung nach einem der Ansprüche 1 bis 7, bei der die erste Schaltung (40) ein erstes Modul (42) konfiguriert zum Liefern, bei jedem Zyklus des Taktsignals, von Datensätzen, wobei jeder Satz einen Startwert der Rampe, die Steigung der Rampe und eine Verzögerung aufweist, wobei die Verzögerung von einem Satz zum anderen variiert, und ein zweites Modul (44) konfiguriert zum Liefern, für jeden Satz, eines digitalen Werts des digitalen Signals gleich der Summe des Startwerts der Rampe und des Produkts der Steigung der Rampe und der Verzögerung.

9. Elektronische Schaltung nach einem der Ansprüche 1 bis 8, wobei der erste Speicher (30) Nout Speicherblöcke parallel aufweist.

10. Elektronische Schaltung nach einem der Ansprüche 1 bis 9, aufweisend einen dritten Speicher (12), in dem, für jede Rampe der Aufeinanderfolge von Rampen, dritte Daten gespeichert sind, die den Startwert der Rampe, den Endwert der Rampe und die Dauer der Rampe aufweisen, wobei die elektronische Schaltung ferner eine zweite Schaltung (20) aufweist, die konfiguriert ist zum Liefern, basierend auf den dritten Daten, der ersten Daten und der zweiten Daten, und zum Schreiben der ersten Daten in den ersten Speicher (30) und zum Schreiben der zweiten Daten in den zweiten Speicher (32).

11. Elektronische Schaltung nach Anspruch 10, wobei die zweite Schaltung (20) konfiguriert ist zum Verarbeiten der dritten Daten in Chargen von Nout aufeinanderfolgenden Rampen.

12. Elektronische Schaltung nach Anspruch 10 oder 11, wobei die zweite Schaltung (20) ein drittes Modul (22) aufweist, das konfiguriert ist zum Bestimmen, für jede Rampe, der Steigung der Rampe, und ein viertes Modul (24), das konfiguriert ist zum Bestimmen der Gesamtdauer, die vom Beginn der Abfolge von Rampen bis zum Ende der Rampe verstrichen ist, und der Anzahl von Zyklen des Taktsignals, die in der Gesamtdauer enthalten sind.

13. System (10) aufweisend die elektronische Schaltung nach einem der Ansprüche 1 bis 12, einen Digital-Analog-Wandler (6), konfiguriert zum Umwandeln des digitalen Signals (Sn) in ein analoges Signal (Sa), und Quantenbit-Speicherzellen (2), die das analoge Signal empfangen.

14. Verfahren zum Liefern eines digitalen Signals (Sn), wobei ein analoges Signal, das durch Digital-Analog-Wandlung des digitalen Signals erhalten wird, eine Folge von Rampen aufweist, wobei das Verfahren das Liefern, bei jedem Zyklus eines Taktsignals, einer Anzahl Nout von aufeinanderfolgenden digitalen Werten des digitalen Signals aufweist, wobei Nout größer als 1 ist, wobei das Verfahren das Bereitstellen eines ersten Speichers (30) aufweist, in dem, für jede Rampe, erste Daten gespeichert sind, die einen Startwert der Rampe, die Steigung der Rampe und eine verbleibende Dauer der Rampe in dem letzten Zyklus des Taktsignals, in dem sich die Rampe erstreckt, aufweist, das Bereitstellen eines zweiten Speichers (32), in dem zweite Daten in Bezug auf die Anzahl der Zyklen des Taktsignals, über die sich einige der Rampen erstrecken, gespeichert sind, das Auslesen, aus dem ersten Speicher, der ersten Daten in Bezug auf eine Vielzahl von aufeinanderfolgenden Rampen und, aus dem zweiten Speicher, der zweiten Daten, die mit der Vielzahl von aufeinanderfolgenden Rampen verknüpft sind, und das Liefern der digitalen Werte basierend auf den ersten und zweiten gelesenen Daten.

## Claims

1. Electronic circuit (10) for providing a digital signal (Sn), an analog signal obtained by digital-to-analog conversion of the digital signal comprising a succession of ramps, the electronic circuit being clocked by a clock signal, the electronic circuit being configured to supply a number Nout of successive digital values of the digital signal at each cycle of the clock signal, Nout being greater than 1, the electronic circuit comprising a first memory (30) in which are stored, for each ramp, first data comprising a start value of the ramp, the slope of the ramp, and a remaining duration of the ramp in the last cycle of the clock signal in which the ramp extends, and a second memory (32) in which are stored second data relative to the numbers of cycles of the clock signal over which some of the ramps extend, and a first circuit (40) configured to read from the first memory the first data relative to a plurality of successive ramps and from the second memory the second data associated with said plurality of successive ramps, and to provide said digital values based on the first and second read data.

2. Electronic circuit according to claim 1, wherein the first circuit (40) is configured to read in parallel from the first memory (30) the first data relative to Nout successive ramps, to read from the second memory the second data associated with said Nout successive ramps, and to supply, at a cycle of the clock signal, Nout digital values of the digital signal forming part of from one to Nout ramps among said Nout ramps.

3. Electronic circuit according to claim 2, wherein the first circuit (40) comprises Nout interpolation circuits (46) in parallel, each interpolation circuit being configured to calculate, at a cycle of the clock signal, one of the Nout digital values of the digital signal forming part of from one to Nout ramps among said Nout successive ramps.

4. Electronic circuit according to any of claims 1 to 3, wherein the first data stored in the first memory (30) comprise, for each ramp, coefficients of a polynomial of a degree greater than or equal to 2, the slope of the ramp being the coefficient of degree 1 of the polynomial, the first circuit (40) being configured to supply said digital values of ramps corresponding to polynomial functions.

5. Electronic circuit according to any of claims 1 to 4, wherein Nout is a power of two, in particular 2, 4, 8, or 16.

6. Electronic circuit according to any of claims 1 to 5, wherein the first circuit (40) is configured to read, from the first memory (30), simultaneously the first data of Nout successive ramps.

7. Electronic circuit according to any of claims 1 to 6, wherein the first circuit (40) is configured to read, from the second memory (32), simultaneously the second data of Nout successive ramps.

8. Electronic circuit according to any of claims 1 to 7, in which the first circuit (40) comprises a first module (42) configured to supply, at each cycle of the clock signal, sets of data, each set comprising a start value of the ramp, the slope of the ramp, and a delay, the delay varying from one set to the other, and a second module (44) configured, for each set, to supply a digital value of the digital signal equal to the sum of the start value of the ramp and of the product of the slope of the ramp and of the delay.

9. Electronic circuit according to any of claims 1 to 8, wherein the first memory (30) comprises Nout memory blocks in parallel.

10. Electronic circuit according to any of claims 1 to 9, comprising a third memory (12) in which are stored, for each ramp of the succession of ramps, third data comprising the start value of the ramp, the end value of the ramp, and the duration of the ramp, the electronic circuit further comprising a second circuit (20) configured to supply, based on the third data, the first data and the second data, and to write the first data into the first memory (30) and to write the second data into the second memory (32).

11. Electronic circuit according to claim 10, wherein the second circuit (20) is configured to process the third data in batches of Nout successive ramps.

12. Electronic circuit according to claim 10 or 11, wherein the second circuit (20) comprises a third module (22) configured to determine, for each ramp, the slope of the ramp, and a fourth module (24) configured to determine the total duration elapsed from the start of the succession of ramps to the end of the ramp and the number of cycles of the clock signal contained in said total duration.

13. System (10) comprising the electronic circuit according to any of claims 1 to 12, a digital-to-analog converter (6) configured to convert the digital signal (Sn) into an analog signal (Sa), and quantum bit storage cells (2) receiving the analog signal.

14. Method of supplying a digital signal (Sn), an analog signal obtained by digital-to-analog conversion of the digital signal comprising a succession of ramps, the method comprising the supply, at each cycle of a clock signal, of a number Nout of successive digital values of the digital signal, Nout being greater than 1, the method comprising the provision of a first memory (30) in which are stored, for each ramp, first data comprising a start value of the ramp, the slope of the ramp, and a remaining duration of the ramp in the last cycle of the clock signal in which the ramp extends, the provision of a second memory (32) in which are stored second data relative to the numbers of cycles of the clock signal over which some of the ramps extend, the reading, from the first memory, of the first data relative to a plurality of successive ramps and, from the second memory, of the second data associated with said plurality of successive ramps, and the supply of said digital values based on the first and second read data.

Fig 1

Fig 2

Fig 3

Fig 4

Fig 5

Fig 6

Fig 7

Fig 8

Fig 9

Fig 10

Fig 11

Fig 12

A)

28

write
address = i

3

B)

28

3
2
1

write
address = i

4

C)

28

Buffer size >=4

7
6
5
4
3
2
1

write
address = i

1

D)

28

Buffer size >=4

8
7
6
5

write
address = i+1

3

E)

28

11
10
9

write
address = i+2

3

F)

28

Buffer size >=4

14
13
12
11
10
9

write
address = i+2

2

Fig 13

24

SUM1₁  SUM2₂  SUM3₄  SUM4₈  SUM5₁

dur[0]

total_dur[0]

SUM5₁₅

total_dur[15]

dur[15]

SUM1₁₅  SUM2₁₅  SUM3₁₅  SUM4₁₅

Cycle 1    Cycle 2

Fig 14

44

Fig 15

32

read_data_address
shift_data, next_index

if cycle==0

Cycles[i+3] Index[i+3] → Cycles[i+1] Index[i+1]

if cycle==0,
wr_addr/2 even

cycle-=1

Cycles[i+2] Index[i+2]

Current_cycle Current_index

if cycle==0, wr_addr/2 odd

if cycle==0, wr_addr+=2

wr_addr

Fig 16

Fig 17

Fig 18

FO1

FO3

FO2

FO4

Nwfm

12, 30

Nramp

FO1    FO2    FO3    FO4

12, 30

FO3

FO4

FO1    FO2    FO3

Fig 19

10

30

**Mémoire données**

Start_val Coeff1 |
Coeff 2 | ... |Rest

**Mémoire contrôle**

Cycles Index

40

**Execute**

data interpreter

42

Fetch

44

46

interpolator

Sn

Value | Coeff1 | Coeff 2 | ... | Offset | Dur

Fig 20

200

10

Sn

1202

Sn'

6

Sn"

204

Fig 21

Fig 22

Fig 23

Fig 24

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2301359
- FR 2300946

- US 2009231479 A1